# EUROPÄISCHE PATENTANMELDUNG

(11) **EP 3 206 286 A1**
(43) Veröffentlichungstag der Anmeldung: **16.08.2017**
(21) Anmeldenummer: 16155025.6
(22) Anmeldetag: 10.02.2016
(51) Int. Cl.: H02M 1/32, H02M 1/088, H03K 17/12, H02H 9/04, H02H 7/12, H03K 17/06

(54) **GATE VOLTAGE OVERDRIVE FOR SHORT TERM PEAK CURRENT CONTROL OF IGBT SWITCHES**

(71) Anmelder: GE Energy Power Conversion Technology Ltd, Rugby Warwickshire CV21 1BU (GB)
(72) Erfinder: JAKOB, Roland, 12277 Berlin (DE); GESKE, Martin, 12277 Berlin (DE); LUTZ, Josef, 09126 Chemnitz (DE); KOWALSKY, Jens, 09126 Chemnitz (DE)
(74) Vertreter: Rüger, Barthelt & Abel

(57) **Zusammenfassung**

Es ist eine Einrichtung (2) zur bedarfsweisen Kommutierung eines elektrischen Stroms von einem ersten Leitungszweig (14, 3; 36) zu einem anderen, zweiten Leitungszweig (4; 41; 71) geschaffen, die mehrere Leistungshalbleiterschaltelemente (7; 47; 53), die in Reihe und/oder parallel zueinander in dem zweiten Leitungszweig (4; 41; 71) angeordnet sind, und eine Ansteuereinheit (18; 51) zur Ansteuerung der mehreren Leistungshalbleiterschaltelemente (7; 47; 53) aufweist. Die Ansteuereinheit (18; 51) ist dazu eingerichtet, an die mehreren Leistungshalbleiterschaltelemente (7; 47; 53) jeweils eine erhöhte Ansteuerungsspannung (V_{GE}) anzulegen, deren Höhe oberhalb der für den Dauerbetrieb spezifizierten maximal zulässigen Ansteuerungsspannung liegt, um die mehreren Leistungshalbleiterschaltelemente leitend zu schalten oder zu halten und einen erhöhten Stromfluss durch diese zu bewirken, dessen Stromstärke wenigstens dem doppelten Nennbetriebsstrom entspricht. Die Ansteuereinheit (18; 51) ist ferner dazu eingerichtet, die mehreren Leistungshalbleiterschaltelemente nach einer jeweils vorgesehenen kurzen Einschaltdauer durch Abschalten der Ansteuerungsspannung (V_{GE}) wieder auszuschalten, während sie einen erhöhten Stromfluss führen. Die Einrichtung (2) kann dadurch für eine höhere Leistung im Betrieb ausgelegt werden, oder bei einer gegebenen Betriebsleistung kann die Halbleiterfläche und Baugröße der Einrichtung (2) reduziert werden.

## Beschreibung

Die vorliegende Erfindung betrifft eine Einrichtung zur bedarfsweisen kurzzeitigen Übernahme eines elektrischen Stroms von einer Energieübertragungs- oder -verteilungsvorrichtung und insbesondere eine derartige Einrichtung, die mehrere Leistungshalbleiterschaltelemente aufweist, die in Reihe und/oder parallel zueinander in einem Leitungszweig angeordnet sind, auf den der Strom bedarfsweise kommutiert werden soll.

Leistungshalbleiterbauelemente, wie z.B. IGBTs (Insulated Gate Bipolar Transistor), BIGTs (Bi-mode Insulated Gate Transistor), MOSFETs (Metal Oxid Semiconductor Field Effect Transistor), und dgl., werden u.a. zum Gleich- und Wechselrichten von elektrischen Spannungen und Strömen verwendet. Hierzu geeignete Stromrichter weisen in der Regel mehrere Leistungshalbleiterschaltelemente auf. Es sind Stromrichter in unterschiedlichen Topologien für unterschiedliche Anwendungen, wie z.B. zur Kopplung elektrischer Netze mit drehzahlvariablen Antrieben sowie zum Energieaustausch zwischen zwei elektrischen Netzen, für unterschiedliche Leistungsniveaus bekannt.

Mit fortwährender Entwicklung von Leistungshalbleiterschaltern werden stets neuere Stromrichter- und andere Schaltungstopologien für immer höhere Leistungs- und Spannungsbereiche gewünscht und entwickelt. Im Mittel- und Hochspannungsbereich werden bspw. zunehmend Stromrichter eingesetzt, die eine Vielzahl von in Reihe und/oder parallel zueinander angeordneten Leistungshalbleiterschaltelementen aufweisen, um eine hohe Sperrfähigkeit und/oder eine hohe Stromtragfähigkeit für die jeweiligen Anwendungen zu schaffen und die Spannungen auf höchste Niveaus bis in Bereiche der Hochspannungsgleichstromübertragung (HGÜ) zu erhöhen. Es sind auch modulare Mehrpunktstromrichter entwickelt worden, die in jedem Zweig eine Anzahl gleichartiger Zellen oder Submodulen aufweisen, die jeweils durch eine Brückenschaltung mit ansteuerbaren Leistungshalbleiterschaltern und einem internen Kondensator zur Zwischenspeicherung elektrischer Energie gebildet ist. Durch die modulare Bauweise ist der Stromrichter für unterschiedliche Leistungen und Anwendungen individuell skalierbar. Modulare Mehrpunktstromrichter sind bspw. aus der DE 101 03 031 A1, der DE 10 2010 046 142 A1 oder der EP 1 497 911 B1 bekannt.

In sehr hohen Leistungsbereichen wird eine zunehmend große Halbleiterfläche für die Halbleiterleistungsbauelemente benötigt, die entsprechend großes Bauvolumen und hohe Kosten der Stromrichter bedingt. Auch der Aufwand zur Kühlung und für die Ansteuerung der Stromrichter steigt erheblich. Es gibt Anwendungen, bei denen Stromrichter zwar bei hohen Leistungen, jedoch nur in relativ kurzen Betriebszeiten eingesetzt werden. Es besteht der Wunsch, für diese Anwendungen die übertragbare Leistung zu erhöhen, ohne den Aufwand für die Schaltungsanordnung und die Steuerung des Stromrichters zu erhöhen. Umgekehrt besteht der Wunsch, bei einer gegebenen hohen Nennleistung der Stromrichter für derartige Anwendungen die Halbleiterfläche der Leistungsschalter und die Kosten und den Aufwand für die Implementierung und den Betrieb der Stromrichter zu reduzieren bzw. die Leistungshalbleiterbauelemente besser auszunutzen.

Außer Stromrichtern gibt es zahlreiche andere Anwendungen, in denen eine Mehrzahl in Reihe und/oder parallel geschalteter Leistungshalbleiterschaltelemente eingesetzt werden, um hohe Strombelastungen und Sperrspannungen zu ermöglichen. Bspw. werden bei Frequenzumrichtern zur Speisung von Motoren sog. "Bremschopper" zur Überwachung und Kontrolle der Zwischenkreisspannung eingesetzt. Bei Bremsvorgängen derartiger Motoren kann generatorischer Strom über den motorseitigen Stromrichter zurück in den Zwischenkreis fließen und zu einer Zwischenkreisspannung oberhalb der zulässigen Werte führen. Übersteigt die Zwischenkreisspannung eine Schwellenspannung, so wird kurzzeitig der Bremschopper elektronisch zugeschaltet, an dem ein sog. Bremswiderstand angeschlossen ist, der die überschüssige Energie in dem Zwischenkreis in thermische Energie umwandelt und so die maximale Zwischenkreisspannung begrenzt. Dieser Vorgang wird bei Bedarf wiederholt. Für hohe Leistungsbereiche kann es hier ebenfalls erforderlich sein, den elektronischen Schalter des Bremschoppers mit einer Vielzahl von in Reihe und/oder parallel geschalteten Leistungshalbleiterschaltelementen zu realisieren.

Ähnliche Chopper-Widerstands-Einrichtungen können auch in HGÜ-Systemen (vgl. S. K. Chaudhary at al., "Chopper Controlled Resistors in VSC-HVDC Transmission for WPP with Full-scale Converters", Sustainable Alternative Energy (SAE), 2009 IEEE PES/IAS Conference on, Seiten 1-8) oder aber auch in Gleichstromübertragungssystemen bis zum Mittelspannungsbereich bei Stromrichtern eingesetzt werden, die die über HGÜ-Leitungen empfangene Gleichspannungsleistung in eine für ein nachgeschaltetes Verteilungs- oder Versorgungsnetz geeignete Wechselspannungsleistung umwandeln. Wenn ein Fehler in dem nachgeschalteten Wechselspannungsnetz auftritt und die Leistungsübertragung zu dem Netz behindert ist, können die Chopper-Widerstands-Einrichtungen auch hier durch den kurzzeitigen Verbrauch überschüssiger Energie in einem angeschlossenen Widerstand Überspannungen an der HGÜ-Leitung bzw. in dem Stromrichtersystemen begrenzen. Insbesondere bei Hochspannungs- und Hochleistungsanwendungen sind hierzu ein enormer Halbleitereinsatz und eine enorme Baugröße erforderlich, die anteilig am gesamten Stromrichter im hohen einstelligen Prozentbereich liegen kann. Die Kosten und der Aufwand für die Implementierung und den Betrieb sind erheblich. Eine Reduktion von diesen bei Sicherstellung einer stabilen, robusten Funktionsweise wäre erwünscht.

Des Weiteren sind DC-Trennschalter für HGÜ-Systeme bekannt, die eine Vielzahl in Reihe geschalteter Leistungshalbleiterbauelemente verwenden. Bspw. sind aus der WO 2011/057675 A1 und der EP 2 780 923 B1 sog. hybride DC-Leistungsschalter bekannt, die auf einer Kombination aus einem elektronischen Hauptschalter und einer zu diesem parallel geschalteten Reihenschaltung eines elektronischen Hilfsschalters mit einem schnellen mechanischen Trennschalter basieren. Sowohl der Hilfsschalter als auch der Hauptschalter weisen mehrere in Reihe geschaltete Leistungshalbleiterschaltelemente auf, deren Anzahl bei dem Hilfsschalter geringer ist, so dass er für eine geringere Nennleistung und für geringere Leitungsverluste als der Hauptschalter eingerichtet ist. Im Normalbetrieb sind der Hilfsschalter und der mechanische Trennschalter geschlossen, während der Hauptschalter geöffnet oder geschlossen sein kann. Der Strom fließt somit, ohne Auftreten eines Fehlers, immer durch den niederohmigen Hauptstrompfad. Wenn bspw. ein Kurzschlussfehler innerhalb der Gleichspannungsübertragungsstrecke bzw. des Gleichspannungsnetzes erkannt wird, wird der hybride Leistungsschalter ausgelöst, indem zuerst der Hilfsschalter geöffnet wird, wodurch der Strom von dem Hauptstrompfad auf den Bypasspfad mit dem Hauptschalter kommutiert wird. Anschließend wird der mechanische Trennschalter geöffnet, um den Hilfsschalter von der übertragenen Spannung zu trennen, und danach wird der Hauptschalter geöffnet, was zu einer Kommutierung des Stroms von dem Bypasspfad zu einem Überspannungsableiter führt, der parallel zu dem Hauptschalter angeordnet ist.

Derartige hybride DC-Leistungsschalter ermöglichen ein schnelles Öffnen und Isolieren fehlerhafter Teile von Übertragungsstrecken und Wiedereinschalten fehlerfreier Teile bei geringen Leistungsverlusten. Der Hauptschalter, der je nach der erforderlichen Sperrspannung wenigstens 2 oder mehrere, für HGÜ-Anwendungen sogar 10 oder mehr als 50 Leistungshalbleiterschaltelemente aufweisen kann, ist nur für kurze Zeit, bei der Auslösung des Hybridschalters im Einsatz. Dessen Leitungsverluste spielen kaum eine Rolle. Allerdings können derartige Hybridschalter für eine HGÜ-Anwendung eine enorme Halbleiterfläche für den Hauptschalter und viel Bauraum insgesamt für den Hybridschalter, dessen Kühl- und Ansteuerungseinrichtungen erfordern. Dieser Bauraum kann hier ebenfalls im Vergleich zu einem gesamten Stromrichter einen Anteil im hohen einstelligen Prozentbereich einnehmen. Auch hier ist es erwünscht, die Halbleiterfläche und den Bauraum zu reduzieren und Implementierungs- und Betriebskosten zu senken.

IGBTs sind durch einen Nennstrom I_{C nom} gekennzeichnet. Ihr typischer Arbeitsbereich reicht bis zum doppelten Nennstrom. Auch dreifacher Nennstrom kann ggf. abgeschaltet werden. Ferner sind IGBTs durch einen Kurzschlussstrom I_{SC} beschrieben, der je nach IGBT das Dreifache bis Fünffache des Nennstroms I_{C nom} beträgt. Es wurde herausgefunden, dass bei erhöhter Gate-Emitter-Spannung auch Ströme von mehr als dem dreifachen Nennstrom I_{C nom} geschaltet werden können.

Bspw. ist es aus der DE 10 2010 006 525 B4 und der EP 2 747 260 A2 ist bekannt, dass wiederabschaltbare Halbleiterschaltelemente, insbesondere IGBTs, kurzzeitig außerhalb der spezifizierten Parameter betrieben werden können, um eine Entsättigung zu vermeiden und hohe Lastströme zu ermöglichen. Die DE 10 2010 006 525 B4 beschreibt eine Vorrichtung zur Ableitung von Stoßströmen oder transienten Überspannungen bspw. in Folge eines Blitzeinschlages mit einem wiederabschaltbaren Halbleiterschaltelement, wobei die Einschaltung durch das statische Anlegen einer Gate-Emitter-Spannung außerhalb des für seine Gate-Emitter-Spannung für den Dauerbetrieb spezifizierten Bereichs erreicht wird. Üblicherweise werden IGBTs in einem Arbeitspunkt bei einer Gate-Emitter-Spannung V_{GE} = 15 V betrieben, wobei nach der Spezifikation der Hersteller die Gate-Emitter-Spannung für den Dauerbetrieb typischerweise 20 V nicht übersteigen darf, weil ansonsten die Lebensdauer der dünnen isolierenden Oxidschicht unterhalb des Gates begrenzt ist. Für die kurzzeitigen bzw. transienten Stoßströme in Folge von Blitzeinschlägen wird eine erhöhte Gate-Emitter-Spannung von bspw. 30 V - 50 V vorgeschlagen. Das Schaltelement wird wieder abgeschaltet, nachdem der kurzzeitige bzw. transiente Stoßstrom abgeklungen ist.

Die EP 2 747 260 A2 beschreibt einen dreiphasigen Stromrichter mit IGBTs als Leistungshalbleiterschalter, wobei im Falle eines Kurzschlusses in einem der Zweige des Stromrichters die IGBTs der anderen, fehlerfreien Zweige dauerhaft leitend geschaltet werden, indem an sie eine erhöhte Gate-Emitter-Spannung in einem Bereich zwischen etwa 30 V und etwa 70 V, außerhalb des zulässigen spezifizierten Bereiches, angelegt wird. Durch die daraus resultierende Erhöhung der Zweigströme in den fehlerfreien Zweigen kann eine Symmetrierung der Kurzschlussströme durch den Motor erreicht werden, und Pendeldrehmomente in dem Motor können vermieden werden.

Ausgehend hiervon ist es eine Aufgabe der vorliegenden Erfindung, eine Einrichtung zur bedarfsweisen kurzzeitigen Übernahme des elektrischen Stroms von einer Energieübertragungs- oder -verteilungsvorrichtung zu schaffen, die dazu eingerichtet ist, bedarfsweise kurzzeitig sehr hohe Leistungen übertragen zu können. Insbesondere ist es eine Aufgabe der vorliegenden Erfindung, einfache Maßnahmen vorzuschlagen, um die übertragbare Leistung einer derartigen Einrichtung zur bedarfsweisen kurzzeitigen Übernahme zu maximieren und/oder bei einer gegebenen übertragbaren Leistung den Aufwand und die Kosten für die Implementierung und den Betrieb der Einrichtung zu verringern. Dies bei sicherer und robuster Funktionsweise.

Diese Aufgabe wird durch eine Einrichtung zur bedarfsweisen kurzzeitigen Übernahme eines elektrischen Stroms von einer Energieübertragungs- oder -verteilungsvorrichtung mit den Merkmalen des Anspruchs 1 und durch eine Verwendung einer Reihen- und/oder Parallelschaltung mehrerer Leistungshalbleiterschaltelemente nach Anspruch 13 gelöst. Besonders vorteilhafte Ausführungsformen der Erfindung sind Gegenstand von Unteransprüchen.

Gemäß einem Aspekt der Erfindung ist eine Einrichtung zur bedarfsweisen kurzzeitigen Übernahme eines elektrischen Stroms von einer Energieübertragungs- oder -verteilungsvorrichtung geschaffen, die wenigstens einen Leitungszweig, der mit der Energieübertragungs- oder -verteilungsvorrichtung verbunden ist, mehrere Leistungshalbleiterschaltelemente, die in Reihe und/oder parallel zueinander in dem wenigstens einen Leitungszweig angeordnet sind, und eine Ansteuereinheit zur Ansteuerung der mehreren Leistungshalbleiterschaltelemente aufweist. Die Ansteuereinheit ist dazu eingerichtet, an die mehreren Leistungshalbleiterschaltelemente jeweils eine erhöhte Ansteuerungsspannung, deren Höhe oberhalb der für den Dauerbetrieb spezifizierten maximal zulässigen Ansteuerungsspannung liegt, anzulegen, um die mehreren Leistungshalbleiterschaltelemente einzuschalten und einen erhöhten Stromfluss durch diese zu bewirken, dessen Stromstärke wenigstens dem doppelten Nennbetriebsstrom entspricht. Die Ansteuereinheit ist ferner dazu eingerichtet, die mehreren Leistungshalbleiterschaltelemente durch Abschalten der Ansteuerungsspannung wieder auszuschalten, während sie einen erhöhten Stromfluss führen.

Der Erfindung liegt die Erkenntnis zugrunde, dass in Anwendungen, bei denen der Strom im Betrieb nur kurzzeitig auf die mehreren in Reihe und/oder parallel zueinander angeordneten Leistungshalbleiterschaltelemente kommutiert werden soll, aufgrund der größeren Stromtragfähigkeit der Leistungshalbleiterschaltelemente in Folge der über die zulässigen Grenzwerte hinaus erhöhten Ansteuerungsspannung die Halbleiterfläche von diesen und somit der gesamte Bauraum der Einrichtung für eine gegebene zu übertragende hohe Leistung deutlich verringert werden können. Dadurch kann der Aufwand für die Implementierung, Kühlung und den Betrieb der Einrichtung reduziert werden, was die Implementierungs- und Betriebskosten senkt.

In der zuvor erwähnten Einrichtung wird die positive Ansteuerspannung vorzugsweise so gewählt, dass sie kurzeitig wenigstens über dem 1,5-fachen der vom Hersteller maximal zulässigen Ansteuerspannung liegt. Sie kann bis zu dem 4-fachen oder sogar mehr der maximal zulässigen Ansteuerspannung betragen.

Zusätzlich oder alternativ kann die abzuschaltende Stromstärke über dem bei empfohlener positiver Ansteuerungsspannung V_{GE} gegebenen Kurzschlussstrom I_{SC} liegen und im Allgemeinen bis zum 14-fachen, ggf. bis zum wenigstens 20-fachen des spezifizierten Nominalstroms (I_{C nom}) betragen. In Laborversuchen konnte das 27-fache des Nominalstroms erfolgreich abgeschaltet werden.

In bevorzugten Anwendungen sind die verwendeten Leistungshalbleiterschaltelemente vorzugsweise durch IGBTs gebildet, die die Vorteile eines spannungsgesteuerten Schaltverhaltens, wie bei MOSFETs, bei gutem Durchlassverhalten durch eine bipolare Funktionsweise, wie bei Bipolartransistoren, und einer nur geringen Ansteuerleistung bieten und inzwischen für hohe Leistungen mit Strömen im kA-Bereich und Spannungen im kV-Bereich erhältlich sind. Dies ermöglicht Anwendungen der erfindungsgemäßen Einrichtung für Hochleistungsanwendungen, z.B. für die Hochspannungsgleichstromübertragung (HGÜ), so dass die Energieübertragungs- oder -verteilungsvorrichtung bspw. eine HGÜ-Leitung sein kann. Bei IGBTs liegt der Arbeitspunkt für den Dauerbetrieb im Allgemeinen bei einer Ansteuerungsspannung bzw. Gate-Emitter-Spannung von etwa 15 V, während die spezifizierte maximal zulässige Gate-Emitter-Spannung im Allgemeinen 20 V beträgt. Erfindungsgemäß wird die Gate-Emitter-Spannung für die Leitendschaltung der Reihen- und/oder Parallelschaltung von Leistungshalbleiterschaltelementen bei 30 bis 50 V oder sogar darüber, bis zu etwa 70 V gewählt, was es ermöglicht, die erforderliche Halbleiterfläche auf die Hälfte oder sogar darunter zu reduzieren. Der erhöhte Strom, der durch die Reihen- und/oder Parallelschaltung der Leistungshalbleiterschaltelemente dann im Betrieb fließt, ist größer als der doppelte Nennbetriebsstrom, kann sogar das Fünffache oder bis zu Zehnfache oder mehr des Nennstroms betragen. Bei Verwendung von IGBTs kann auch ein Mehrfaches des Nennstroms sicher und zuverlässig durch Abschalten bzw. Wegnahme der Gate-Emitter-Spannung unterbrochen werden. Gegebenenfalls wird dies durch zusätzliche Maßnahmen, wie auch hier nachstehend erläutert, unterstützt.

Prinzipiell ist es auch möglich, andere Leistungshalbleiterschaltelemente außer IGBTs, wie bspw. BIGTs, MOSFETS oder dgl., in der erfindungsgemäßen Weise zu betreiben.

In einer besonders bevorzugten Ausführungsform ist die erfindungsgemäße Einrichtung ein Teil eines hybriden Gleichstrom(DC)-Leistungsschalters, vorzugsweise für HGÜ-Anwendungen, der einen zu der Energieübertragungs- oder -verteilungsvorrichtung in Reihe geschalteten oder in diese eingefügten Hauptstromzweig, der eine Reihenschaltung aus einem elektronischen Hilfsschalter und einem schnellen mechanischen Trennschalter aufweist, und einen Bypasszweig aufweist, der parallel zu dem Hauptstromzweig angeschlossen ist und einen elektronischen Hauptschalter aufweist, der die mehreren Leistungshalbleiterschaltelemente aufweist. Derartige hybride DC-Leistungsschalter sind an sich bekannt, werden aber innerhalb der spezifizierten Parameterbereiche betrieben. Die Erfindung ermöglicht es, die Halbleiterfläche für derartige hybride DC-Leistungsschalter deutlich zu reduzieren, wodurch sich entsprechend auch der gesamte Bauraum sowie der gesamte Implementierungs- und Betriebsaufwand für die hybriden DC-Leistungsschalter deutlich verringern.

In einer Implementierung kann der elektronische Hilfsschalter ein oder mehrere in Reihe geschaltete Leistungshalbleiterschaltelemente, vorzugsweise IGBTs, aufweisen, die insgesamt für eine geringere Nennleistung und für geringere Leitungsverluste ausgelegt sind als die Reihen- und/oder Parallelschaltung der mehreren Leistungshalbleiterschaltelemente des Hauptschalters. Der Hauptschalter kann eine Reihenschaltung aus Leistungshalbleiterschaltelementen (7) aufweisen. Für Hochspannungsanwendungen, einschließlich HGÜ, kann er auch eine Vielzahl von wenigstens 10, vorzugsweise wenigstens 50 oder sogar 100-200 Leistungshalbleiterschaltelemente aufweisen, um die erforderliche Sperrfähigkeit zu bieten. Bspw. müssen die in Reihe geschalteten Leistungshalbleiterschaltelemente des Hauptschalters bei HGÜ-Anwendungen für übertragene DC-Spannungen von bspw. 300-400 kV oder sogar höhere Spannungsniveaus und für Ströme von bspw. 1000-1500 A ausgelegt sein. Dies ist durch die Erfindung relativ aufwandsärmer und kostengünstiger möglich. Beispielweise müsste nach Stand der Technik bei 600 kV und einer Auslegung auf eine Leistung von 1 GW eine Auslegung für den Strom auf circa 1670 A pro IGBT-Einzelelement erfolgen. Die Erfindung erlaubt nun beispielsweise den 5-fachen Strom pro IGBT-Einzelelement. Es wäre also eine Auslegung auf 1670/5 = 334A, bei Abschaltung des 10-fachen Stroms auf 167A ausreichend. Da die Kosten und der Bauraum proportional zum Strom sind, lässt sich somit der Aufwand auf ein Fünftel bzw. ein Zehntel reduzieren.

Der erfindungsgemäße hybride DC-Leistungsschalter kann im normalen Betrieb derart betrieben werden, dass der Hilfsschalter leitend geschaltet ist und der schnelle mechanische Trennschalter geschlossen ist, während der Hauptschalter sich im nichtleitenden Zustand befindet. Er kann hierzu geöffnet oder mit einer nominalen Ansteuerungsspannung vorangesteuert sein. Da die Impedanz des elektronischen Hauptschalters deutlich höher ist als die des Hilfsschalters, fließt der Strom nahezu ausschließlich durch den Hauptstromzweig. Falls ein Fehler, bspw. Kurzschlussfehler in der Energieübertragungs- oder -verteilungsvorrichtung erkannt wird, wird zuerst der elektronische Hilfsschalter geöffnet. Gleichzeitig werden die Leistungshalbleiterschaltelemente des elektronischen Hauptschalters mit der erhöhten Ansteuerungsspannung angesteuert, um den Strom auf den Bypasszweig mit dem Hauptschalter zu kommutieren. Anschließend wird der schnelle mechanische Schalter geöffnet, um den Hilfsschalter gegen die übertragene Spannung zu isolieren, und dann wird der elektronische Hauptschalter durch Abschaltung der erhöhten Ansteuerungs- bzw. Gate-Emitter-Spannung geöffnet, um den erhöhten Stromfluss in dem Bypasszweig zu unterbrechen. Der Strom kommutiert dann z.B. auf einen zu den Leistungshalbleiterschaltelementen parallelen Ableiter bzw. nichtlinearen Widerstand seine Energie wird dort in Wärme umgesetzt.

In einer weiteren bevorzugten Ausführungsform ist die erfindungsgemäße Einrichtung ein Teil eines zwei oder mehrstufigen Stromrichters, vorzugsweise für HGÜ- oder andere Hochleistungsanwendungen. Der Stromrichter kann einen oder mehrere zueinander parallel geschaltete Phasenzweige aufweisen, wobei jeder Phasenzweig wenigstens zwei in Reihe geschaltete elektronische Schalter aufweist, die von der Ansteuereinheit gemäß einem bestimmten Pulsmuster angesteuert werden, um eine erste Leistung mit ersten Strom- und Spannungseigenschaften in eine zweite Leistung mit zweiten Strom- und Spannungseigenschaften umzuwandeln.

In einer Konfiguration können die wenigstens zwei in Reihe geschalteten elektronischen Schalter jeweils mehrere in Reihe und/oder parallel geschaltete Leistungshalbleiterschaltelemente aufweisen, die im Normalbetrieb des Stromrichters mit der erhöhten Ansteuerungsspannung, z.B. Gate-Emitter-Spannung im Falle von IGBTs, gemäß dem bestimmten Pulsmuster angesteuert werden. Somit können in Anwendungen, in denen ein für hohe Leistungen ausgelegter Stromrichter nur zeitweise bzw. kurzzeitig betrieben wird, die Halbleiterfläche und der Aufwand für die Realisierung und den Betrieb des Stromrichters wesentlich reduziert werden. Der Bauraum und das Gewicht derartiger Komponenten können so deutlich reduziert werden. Es sind viele Anwendungen denkbar, bei denen die nötige Lebens- oder Einsatzdauer von vornerein relativ begrenzt ist und sich für die zeitweise bzw. kurzzeitige Anwendung erhöhter Ansteuerungsspannungen eignen.

In einer weiteren bevorzugten Ausführungsform der Erfindung kann der Stromrichter eine Chopper-Widerstands-Einrichtung zum Schutz gegen Überspannung in einem Gleichspannungszwischenkreis des Stromrichters aufweisen, die parallel zu dem einen oder den mehreren parallelen Zweigen des Stromrichters angeschlossen ist und eine Reihenschaltung aus wenigstens einem Widerstand und einem elektronischen Schalter aufweist. Der elektronische Schalter ist durch die mehreren in Reihe und/ oder parallel geschalteten Leistungshalbleiterschaltelemente gebildet, die, wenn die Spannung in dem Gleichspannungszwischenkreis eine vorgegebene Schwellspannung übersteigt, für kurze Zeit, pulsartig, gegebenenfalls wiederholt, bspw. durch Pulsweitenmodulation (PWM), mit der erhöhten Ansteuerungsspannung (bspw. Gate-Emitter-Spannung bei IGBTs) angesteuert werden. Eine derartige Chopper-Widerstands-Einrichtung mit vielen seriell und/oder parallel geschalteten Leistungshalbleiterschaltelementen kann bspw. zum Schutz vor Überspannung in Wechselrichtern mit zentralen oder dezentralen Zwischenkreisen verwendet werden. Sie kann aber auch als eine Bremschopper-Einrichtung für Antriebssysteme verwendet werden, um beim Bremsen überschüssige Energie über einen angeschlossenen Bremswiderstand in thermische Energie umzuwandeln. Jedenfalls kann die Baugröße der Chopper-Widerstands-Einrichtung durch Vorsehen der überhöhten Ansteuerungsspannung deutlich reduziert werden. Die erforderliche Halbleiterfläche kann bis auf ein Fünftel oder sogar darüber hinaus reduziert werden. Der Implementierungs- und Betriebsaufwand und die damit verbundenen Kosten werden gesenkt.

Ferner kann die erfindungsgemäße Einrichtung auch als eine sog. "Crowbar" ausgeführt sein, die eine elektronische Klemmschaltung ist, die als Schutz vor Überspannung vor allem in Gleichstromversorgungen niedriger Spannung eingesetzt wird. Crowbars besitzen als Schaltelemente Thyristoren oder Triacs, die bei Erreichen einer bestimmten Spannung die Versorgungsspannung niederohmig kurzschließen, so dass als Folge bspw. eine Sicherung auslösen kann und die Stromversorgung unterbricht oder spannungsbegrenzend auf zu schützende Stromrichterkomponenten wirkt. Indem die Thyristoren oder Triacs durch eine Reihen- und/oder Parallelschaltung von IGBTs oder dgl. ersetzt werden, kann die Crowbar auch für Mittel- oder Hochspannungen eingesetzt und erfindungsgemäß mit überhöhter Ansteuerungsspannung betrieben werden. Die Crowbar kann ggf. auch zwischen den Phasen eines Drehstromnetzes verschaltet werden. Darüber hinaus kann die Crowbar selbst Bestandteil der eigentlichen Stromrichterschaltung sein zur Umformung der elektrischen Energie sein.

In einer vorteilhaften Weiterbildung der Erfindung, kann die Ansteuereinheit dazu eingerichtet sein, die mehreren Leistungshalbleiterschalelemente zwischen dem Ein- und dem endgültigen Ausschalten mit einer Ansteuerungsspannung auf wenigstens einem Zwischenniveau anzusteuern, das unterhalb desjenigen der erhöhten Ansteuerungsspannung beim Einschalten, jedoch oberhalb der für den Dauerbetrieb spezifizierten maximal zulässigen Ansteuerungsspannung liegt. Es können also Zwischenstufen der Ansteuerungsspannung hinzugefügt werden, so dass die IGBTs bspw. zuerst mit +50 V zum Einschalten, dann mit einer Spannung im Bereich von 20 bis 30 V als Zwischenstufe und schließlich mit -15 V zum endgültigen Abschalten angesteuert werden können. Es sind auch mehrere Zwischenstufen, z.B. auf +30 V und dann auf +20 V, möglich. Dadurch können Schaltverluste und die Abschaltzeit gesteuert und der Schaltverlauf je nach Anwendung und Betriebsumgebung optimiert werden. Bspw. können die di/dt- und dv/dt-Verläufe für den Kollektorstrom und die Kollektor-Emitter-Spannung optimiert und Überspannungen minimiert werden. Es ist auch möglich, mit einer geeigneten Zwischenstufe kurz vor der endgültigen Abschaltung eine Entsättigung der IGBTs zu erreichen, um die Abschaltverluste und die damit verbundene Spitzensperrschichttemperatur beim Abschalten zu reduzieren oder aber auch die Abschaltüberspannung zu reduzieren und die Robustheit der eingesetzten Leistungshalbleiterbauteile gegenüber der Anwendung zu verbessern.

Es können weitere Maßnahmen in der Ansteuereinheit implementiert werden, um Spannungsüberhöhungen (Überspannungen) beim Ausschalten der mehreren Leistungshalbleiterschaltelemente zu reduzieren und eine sichere Abschaltung hoher Ströme, die das Zwei- oder Mehrfache des Nennstroms betragen können, zu fördern. Zu diesen Maßnahmen gehören z.B. eine aktive Steuerung der Abschaltgeschwindigkeit über einen Gate-Widerstand (sog. Soft-Turn-Off) oder mehrere Gate-Widerstände bei IGBTs, ein sanftes Abschalten durch Reduktion der Gate-Emitter-Spannung oder eine Überspannungsbegrenzung durch Spannungsklemmung (sog. Active Clamping), die allesamt in der Technik allgemein bekannt sind. In Verbindung mit der erfindungsgemäß erhöhten Ansteuerungsspannung können diese Maßnahmen die Funktionssicherheit und Robustheit der Einrichtung verbessern.

In einem weiteren Aspekt der Erfindung ist eine Verwendung einer Reihen- und/oder Parallelschaltung mehrerer Leistungshalbleiterschaltelemente, insbesondere IGBTs, in einer Einrichtung zur bedarfsweisen kurzzeitigen Übernahme eines Stroms von einer Energieübertragungs- oder -verteilungsvorrichtung vorgesehen. Die Einrichtung weist wenigstens einen Leistungszweig, der mit der Energieübertragungs- oder -verteilungsvorrichtung verbunden ist und in dem die Reihen- und/oder Parallelschaltung der mehreren Leistungshalbleiterschaltelemente angeordnet ist, auf. Die mehreren Leistungshalbleiterschaltelemente werden im Betrieb, bei Bedarf, vorzugsweise alle, mit einer erhöhten Ansteuerungsspannung angesteuert, deren Höhe oberhalb der für den Dauerbetrieb spezifizierten maximal zulässigen Ansteuerungsspannung liegt, um die mehreren Leistungshalbleiterschaltelemente einzuschalten und einen erhöhten Stromfluss durch diese zu bewirken, dessen Stromstärke wenigstens dem doppelten Nennbetriebsstrom entspricht. Nach einer kurzzeitigen Einschaltdauer werden die mehreren Leistungshalbleiterschaltelemente durch Abschalten bzw. Wegnehmen der Ansteuerungsspannung wieder ausgeschaltet, während sie einen erhöhten Stromfluss führen.

In einer bevorzugten Ausführungsform sind die Leistungshalbleiterschaltelemente IGBTs, und die Höhe der erhöhten Ansteuerungsspannung, also der Gate-Emitter-Spannung, wird in Abhängigkeit von einer vorgegebenen gesamten Lebensdauer bis zu einem Durchbruch einer Gateoxidschicht zwischen einem Gate und einem Emitter der Leistungshalbleiterschaltelemente, unter Schätzung einer erwarteten gesamten Einschaltdauer der Leistungshalbleiterschaltelemente als die Summe der geschätzten Einschaltdauern aller erwarteten Einschaltvorgänge und unter Berücksichtigung einer aufgrund der erwarteten Einschaltvorgänge und kurzzeitig erhöhten Arbeitstemperaturen geschätzten Reduktion der Lebensdauer gewählt, um die vorgegebene Lebensdauer zu erreichen, ohne dass es zu einer Beschädigung der Leistungshalbleiterschaltelemente kommt. Bspw. haben Untersuchungen gezeigt, dass eine Verdopplung der Gate-Emitter-Spannung von üblicherweise 15 V auf 30 V die Lebensdauer um etwa den Faktor 300 verringern kann. Berücksichtigt man den Einfluss auf die Lebensdauer der Einrichtung, kann daraus geschlossen werden, ob die Gate-Emitter-Spannung von 30 V verwendet werden sollte oder ob eine noch höhere Gate-Emitter-Spannung angelegt werden kann.

Im Übrigen betreffen bevorzugte Verwendungen gemäß der Erfindung die Verwendung der Reihen- und/oder Parallelschaltung der Leistungshalbleiterschaltelemente in einem hybriden Gleichstrom(DC)-Leistungsschalter, deren Verwendung als die hochfrequent getakteten Schalter eines Stromrichters oder deren Verwendung als der elektronische Schalter einer Chopper-Widerstands-Einrichtung bspw. für Stromrichter an Hochspannungsgleichstromübertragungs(HGÜ)-Leitungen oder als Bremschopper am Zwischenkreis eines Stromrichters eines Antriebssystems oder als eine Crowbar. Hinsichtlich der Ausführungsformen und Weiterbildungen der erfindungsgemäßen Verwendung und deren Vorteile wird auf die obigen Ausführungen im Zusammenhang mit der erfindungsgemäßen Einrichtung verwiesen, die hier analog gelten.

Weitere vorteilhafte Einzelheiten von Ausführungsformen der Erfindung ergeben sich aus Unteransprüchen, der Zeichnung sowie der zugehörigen Beschreibung. Die Erfindung ist nachstehend anhand einer Zeichnung näher beschrieben, die beispielhafte, keinesfalls beschränkende Ausführungsformen der Erfindung zeigt, wobei gleiche Bezugszeichen in allen Figuren verwendet werden, um gleiche Elemente zu bezeichnen. Es zeigen:
Fig. 1 einen hybriden Gleichstrom(DC)-Leistungsschalter, der eine Vielzahl von in Reihe geschalteten Leistungshalbleiterschaltelementen umfasst, gemäß einer ersten Ausführungsformen der Erfindung, in stark vereinfachter Darstellung;
Fig. 2 gemessene Spannungs- und Stromverläufe beim Schalten eines Leistungshalbleiterschaltelementes, der bspw. in dem hybriden DC-Leistungsschalter nach Fig. 1 verwendbar ist, zur Veranschaulichung des Prinzips von Ausführungsformen der Erfindung;
Fig. 3 eine Prinzipdarstellung eines Ausgangskennlinienfeldes eines IGBTs unter Veranschaulichung eines sogenannten "SURGE"-Betriebs (Überlastbetriebs) in stark vereinfachter Prinzipdarstellung;
Fig. 4a und 4b Spannungs- und Stromverläufe ähnlich Fig. 2 zur Veranschaulichung von Weiterbildungen von Ausführungsformen der Erfindung, in stark vereinfachter Darstellung;
Fig. 5 einen Windpark mit einem Hochspannungsgleichstromübertragungs(HGÜ)-System mit Einrichtungen zur bedarfsweisen kurzzeitigen Übernahme eines elektrischen Stroms von einer Energieübertragungs- oder -verteilungsvorrichtung gemäß weiteren Ausführungsformen der Erfindung;
Fig. 6 ein schematisches Blockschaltbild eines beispielhaften Stromrichters gemäß einer Ausführungsform der Erfindung, in stark vereinfachter Prinzipdarstellung;
Fig. 7 eine Parallelschaltung einer Vielzahl von Leistungshalbleiterbauelementen, die erfindungsgemäß in einer der Einrichtungen bzw. einem der Systeme gemäß den Figuren 1 bis 6 eingesetzt werden kann; und
Fig. 8 eine Schaltungsanordnung eines Submoduls mit Leistungshalbleiterbauelementen, das erfindungsgemäß in einer der Einrichtungen bzw. einem der Systeme gemäß den Figuren 1 bis 6 eingesetzt werden kann.

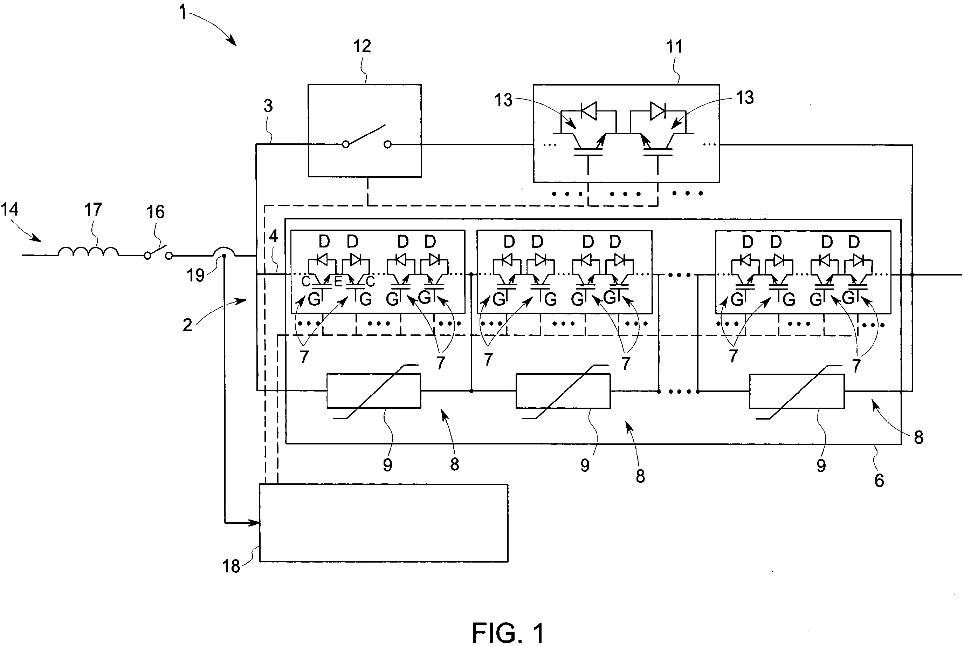

Fig. 1 zeigt einen hybriden Gleichstrom(DC)-Leistungsschalter 1, der eine erste bevorzugte Ausführungsform einer Einrichtung 2 zur bedarfsweisen kurzzeitigen Übernahme bzw. Kommutierung eines elektrischen Stroms gemäß der Erfindung bildet. Der hybride DC-Leistungsschalter 1 kann als sog. "DC-Breaker" (DC-Unterbrecher) bspw. in Hochspannungsgleichstromübertragungs(HGÜ)-Systemen verwendet werden, um im Falle eines Kurzschlusses in einem nachgeschalteten Teil des Gleichstromnetzes den fehlerhaften Teil schnell und sicher zu isolieren, um die Funktion weiterer Teile des Systems weiter aufrechtzuerhalten. Bestehende mechanische DC-Trennschalter sind nicht in der Lage, den Gleichstrom innerhalb von wenigen Millisekunden vollständig zu unterbrechen, wie es bei HGÜ-Anwendungen erforderlich ist. Außerdem benötigen sie komplexe Maßnahmen, um Lichtbögen beim Öffnen der Trennschalter zu vermeiden bzw. zu löschen. Halbleiterbasierte Gleichstromunterbrecher können äußerst schnell und lichtbogenfrei geschaltet werden. Der hybride DC-Leistungsschalter 1 überwindet diese Unzulänglichkeit und ist in der Lage, bei Hochspannungsanwendungen von 50 kV oder mehr, bspw. in einem HGÜ-Netz mit einer Netzspannung von 300-400 kV, Ströme im kA-Bereich, bspw. von bis zu 10 kA oder mehr, zuverlässig zu unterbrechen.

Der hybride DC-Leistungsschalter 1 weist einen Hauptstromzweig 3 und einen zu diesem parallelen Bypasszweig 4 auf. Der Bypasszweig 4 weist einen elektronischen Hauptschalter 6 auf, der hier eine Vielzahl von in Reihe zueinander geschalteten Leistungshalbleiterschaltelementen 7 umfasst. Je nach der Gleichspannung der Anwendung und den Leistungsdaten der verwendeten Leistungshalbleiterschaltelemente 7 kann die Reihenschaltung mehrere zehn oder sogar mehrere Hunderte Leistungshalbleiterschaltelemente 7 umfassen. Wie veranschaulicht, sind vorzugsweise Leistungshalbleiterschaltelemente 7 für beide Stromflussrichtungen vorgesehen, wobei hier bidirektionale Leistungshalbleiterschalter verwendet werden können, die in unterschiedlichen Konfigurationen allgemein verfügbar sind. Liegt die Polarität des Stromes fest, so kann auch ein üblicher unidirektionaler Schalter eingesetzt werden.

Der halbleiterbasierte Hauptschalter 6 ist in mehrere Abschnitte 8 mit einzelnen Überspannungs- bzw. Überstromableitern 9 unterteilt, die zu jeweils mehreren in Reihe geschalteten Leistungshalbleiterschaltelementen 7 parallel angeordnet und durch nichtlineare Widerstände gebildet sind.

Der Hauptstromzweig 3 weist eine Reihenschaltung aus einem elektronischen Hilfsschalter 11 und einem schnellen mechanischen Trennschalter 12 auf. Der elektronische Hilfsschalter 11 ist ebenfalls halbleiterbasiert und weist eine Anzahl von Leistungshalbleiterschaltelementen 13 auf, die vorzugsweise ebenfalls für bidirektionale Stromübertragung eingerichtet sind. Der Hilfsschalter 11 ist für deutlich geringere Sperrspannung als der Hauptschalter 6 eingerichtet und weist hierzu vorzugsweise eine Reihenschaltung von Leistungshalbleiterschaltelementen 13 auf, deren Anzahl deutlich geringer ist als bei dem Hauptschalter 6. Optimal wird nur ein einziger Schalter in Reihe verwendet. Er kann auf niedrigere Spannung ausgelegt sein als die Schalter 7. Liegt die Polarität des Stromes und damit der Energieflussrichtung fest, so kann auch ein üblicher unidirektionaler Schalter eingesetzt werden. Der Schalter 11 kann auch aus anderen Elementen bestehen als die Elemente 7, beispielsweise GCTs.

Der schnelle mechanische Trennschalter 12 ist zum schnellen Schalten im Millisekundenbereich in der Lage und kann bspw. auf bekannter gasisolierter Schaltanlagentechnik oder dgl. basieren.

Wie ferner aus Fig. 1 hervorgeht, kann in einer Energieübertragungs- oder -verteilungsvorrichtung, die hier durch eine Übertragungsleitung 14 gebildet ist, in die der hybride DC-Leistungsschalter 1 eingefügt ist, ferner ein Fehlerstromschutzschalter 16 vorgesehen sein, der dazu dient, nach Auslösung des hybriden DC-Leistungsschalters 1 einen in der Leitung 14 fließenden Reststrom zu unterbrechen. Ferner kann eine Strom begrenzende Drossel 17 vorgesehen sein, um im Falle eines Kurzschlusses z.B. in einem Gleichstromnetz oder einer Sammelschiene, mit dem bzw. der der hybride DC-Leistungsschalter 1 verbunden ist, den Stromanstieg zu begrenzen.

Wie ferner aus Fig. 1 ersichtlich, ist eine Ansteuereinheit 18 vorgesehen, die dazu dient, die Komponenten des hybriden DC-Leistungsschalters 1 im Betrieb anzusteuern. Die Ansteuereinheit 18 kann den gesamten Betrieb des hybriden DC-Leistungsschalters 1 überwachen und steuern und kann hierzu bspw. den Stromfluss durch die Leitung 14 mit einem Stromsensor 19 überwachen. Die Ansteuereinheit 18 könnte auch Ströme in dem Hauptstromzweig 3 und dem Bypasszweig 4 sowie auch die Spannungspotentiale an diesen bedarfsweise überwachen (nicht veranschaulicht). Die Ansteuereinheit könnte auch von einer übergeordneten (hier nicht näher veranschaulichten) Steuereinrichtung selbst gesteuert sein, die die Aufgabe der Überwachung und Steuerung des hybriden DC-Leistungsschalters 1 übernehmen kann, während die Ansteuereinheit 18 lediglich die geeigneten Ansteuersignale für die Leistungshalbleiterschaltelemente 7, 13 generieren und anlegen kann. Die Ansteuereinheit 18 könnte auch in mehrere, den einzelnen Leistungshalbleiterschaltelementen 7 oder jeweils einer Gruppe von diesen zugeordnete Ansteueruntereinheiten unterteilt sein (nicht veranschaulicht).

Der soweit beschriebene hybride DC-Leistungsschalter 1 funktioniert wie folgt:
Während des normalen Betriebs ist der schnelle mechanische Trennschalter 12 geschlossen und die Leistungshalbleiterschaltelemente 13 des elektronischen Hilfsschalters 11 sind ebenfalls geschlossen bzw. leitend geschaltet. Bei geschlossenem DC-Breaker 16 fließt der Strom dann ausschließlich durch den Hauptzweig 4 und die darin angeordneten Schalter 11 und 12. Der elektronische Hauptschalter 6 kann geschlossen, also leitend geschaltet, oder geöffnet, also nicht leitend geschaltet, sein. Da er eine deutlich größere Impedanz als der Hilfsschalter 11 aufweist, fließt dann kein Strom durch den Bypasszweig 3.

Wenn ein Gleichstromfehler, insbesondere ein Kurzschluss, in dem nachgeschalteten Gleichstromnetz auftritt, wird der Hilfsschalter 11 durch die Ansteuereinheit 18 oder eine andere Ansteuerungseinrichtung angesteuert, um zu öffnen bzw. in den nicht leitenden Zustand überzugehen. Dadurch kommutiert der durch den Hauptstromzweig 3 fließende Strom auf den Bypasszweig 4. Sobald der Hilfsschalter 11 innerhalb von wenigen Mikrosekunden nicht leitend ist und der gesamte Strom auf den Bypassstromzweig 4 kommutiert ist, wird der schnelle mechanische Trennschalter 12 geöffnet. Bei geöffnetem mechanischen Trennschalter 12 kann der Hauptschalter 6 dann den Fehlerstrom unterbrechen.

Sobald der Hauptschalter 6 durch die Ansteuereinheit 18 geöffnet wird, kommutiert der Strom auf die parallelen Ableiter 9 und wird dort in Wärme umgesetzt. Nachdem der Strom weitgehend abgeklungen ist, wird der DC-Breaker 16 bedarfsweise geöffnet, um den Stromfluss vollständig zu unterbrechen.

Der mechanische Trennschalter 12 isoliert den Hilfsschalter 11 gegenüber der primären Spannung über dem Hauptschalter 6 während der Stromunterbrechung. Somit ist die erforderliche Nenn- bzw. Sperrspannung des Hilfsschalters 11 deutlich reduziert. Im leitenden Zustand weist der Hilfsschalter 11 Durchlassspannungen im Bereich von vergleichsweise wenigen Volt auf, so dass die Übertragungsverluste des hybriden DC-Leistungsschalters 1 im Vergleich zu einem reinen halbleiterbasierten Unterbrecher stark verringert sind. Die hohen Leitungsverluste des Hauptschalters 6, die nur während der kurzen Zeitdauer der Kommutierung des Stroms auf den Hauptschalter 6 und weiter auf den Ableiter 9 bei einer Auslösung des hybriden DC-Leistungsschalters 1 anfallen, sind unerheblich.

Um die erforderliche Sperrspannung bereitzustellen, benötigt der elektronische Hauptschalter 6 eine Vielzahl von Leistungshalbleiterschaltelementen 7, die die Strombelastung im Kurzschlussfall aufnehmen. Bei HGÜ-Anwendungen mit einer Spannung von 300-400 kV und bspw. IGBT-Halbleiterschaltern als die Leistungshalbleiterschaltelemente 7 mit Leistungsdaten von bspw. 1,5 kA/3,3 kV können bis zu 200 IGBT-Schalter oder mehr zur Realisierung des Hauptschalters 6 erforderlich sein. Dies stellt eine enorm große Halbleiterfläche dar, welche die Kosten der Realisierung enorm steigert. Ferner sind zusätzliche Einrichtungen zur Kühlung des hybriden Leistungsschalters 1 und zu dessen Überwachung und Steuerung erforderlich. Ein hybrider DC-Leistungsschalter 1 für HGÜ-Anwendungen kann ohne Weiteres anteilig am gesamten Stromrichter einen hohen einstelligen Prozentwert erreichen. Die vorliegende Erfindung ermöglicht es, diese Größe zu reduzieren und den Aufwand und die Kosten im Zusammenhang mit der Implementierung und dem Betrieb des hybriden DC-Leistungsschalters 1 deutlich zu verringern.

Bevor näher auf die Erfindung eingegangen wird, sei bemerkt, dass Fig. 1 IGBTs T als die Leistungshalbleiterschaltelemente 7 veranschaulicht. IGBTs sind allgemein bekannt, zeichnen sich durch ein besonders gutes Schaltverhalten, gutes Durchlassverhalten und eine geringe Ansteuerleistung aus und sind für unterschiedliche Leistungsbereiche im Betrieb einsetzbar. Jeder IGBT T weist eine Steuerelektrode, die Gate G genannt wird, sowie einen Emitter E und einen Kollektor C als weitere Elektroden auf. Vorteilhafterweise ist eine interne Freilaufdiode antiparallel zu dem IGBT T geschaltet, auf die bedarfsweise ein Strom kommutiert werden kann. Prinzipiell könnten aber auch andere Leistungshalbleiterbauelemente, wie bspw. BIGTs, MOSFETs oder dgl. erfindungsgemäß eingesetzt werden. Die hier verwendeten Bezeichnungen Kollektor, Emitter und Gate beziehen sich somit auf die bevorzugte Verwendung von IGBTs als die Leistungshalbleiterschaltelemente 7 (und 13), während für den Fachmann die entsprechenden Bezeichnungen für Anschlüsse und Elektroden anderer vergleichbarer Halbleiterbauelemente ohne Weiteres geläufig sind.

Wie oben erwähnt, ist der hybride DC-Leistungsschalter 1, insbesondere dessen Hauptschalter 6, erfindungsgemäß dazu eingerichtet, die erforderliche Halbleiterfläche und den Bauraumbedarf sowie die damit verbundenen Implementierungs- und Betriebskosten zu optimieren. Hierzu ist die Ansteuereinheit 18 dazu eingerichtet, die Leistungshalbleiterschaltelemente 7 bzw. IGBTs T des Hauptschalters 6 bei Auslösung des hybriden DC-Leistungsschalters 1 mit einer erhöhten Ansteuerungsspannung bzw. Gate-Emitter-Spannung V_{GE} anzusteuern, deren Höhe oberhalb der für den Dauerbetrieb spezifizierten maximal zulässigen Ansteuerungsspannung liegt. Im Allgemeinen werden IGBTs für den Dauerbetrieb mit einer Gate-Emitter-Spannung von etwa 15 V betrieben. Nach den Herstellerspezifikationen darf die Gate-Emitter-Spannung für den Dauerbetrieb typischerweise 20 V nicht übersteigen, weil dies ansonsten zu einem Durchbruch der dünnen isolierenden Gateoxidschicht unterhalb des Gates G und zu einer Zerstörung des IGBTs führen könnte.

Erfindungsgemäß werden die IGBTs 7 des Hauptschalters 6 für eine Kommutierung des Kurschlussstroms von dem Hauptstromzweig 3 auf den Bypasszweig 4 durch Anlegen einer erhöhten Gate-Emitter-Spannung betrieben, die größer ist als die maximal zulässigen 20 V und bspw. 30 V oder 50 V beträgt. Gegebenenfalls kann, wenn statistisch nur wenige Kurzschlüsse in dem Gleichstromnetz zu verzeichnen sind, auch eine Gate-Emitter-Spannung für den Betrieb des Hauptschalters 6 von 70 V gewählt werden.

Diese überhöhte Ansteuerungsspannung hat zur Folge, dass jeder IGBT T des Hauptschalters 6 im Vergleich zu dem Nennbetriebsstrom erhöhte Ströme führen kann, die mindestens das Zweifache und sogar bis zum Zehnfachen oder mehr des Nennbetriebsstroms betragen können. Nachdem dieser erhöhte Strom nur kurzzeitig, nach der Kommutierung des Stroms von dem Hauptstromzweig 3 auf den Bypasszweig 4 bis zum vollständigen Öffnen des Hauptschalters 6, im Allgemeinen während einer Zeitdauer, die kürzer ist als eine Millisekunde oder nur wenige Millisekunden beträgt, fließt, kann die geringe Beeinträchtigung der isolierenden Gateoxidschicht im Betrieb in Kauf genommen und dennoch eine hinreichende Lebensdauer für den hybriden DC-Leistungsschalter 1 sichergestellt werden.

Mit der erfindungsgemäßen Maßnahme, der Erhöhung der Ansteuerungsspannung über den für den Dauerbetrieb spezifizierten maximal zulässigen Bereich hinaus, kann somit der hybride DC-Leistungsschalter 1 für höhere übertragene Gleichspannungen des Netzes verwendet werden. Umgekehrt kann die Anzahl gleichartiger Leistungshalbleiterschaltelemente 7 in dem Hauptschalter 6 für die ausgelegte Strombelastung deutlich reduziert, insbesondere auf die Hälfte oder noch mehr verringert werden.

Dies hat eine entsprechende Reduktion der erforderlichen Halbleiterfläche und der damit verbundenen Kosten des Hauptschalters 6 als solchen und des hybriden DC-Leistungsschalters 1 insgesamt zur Folge. Auch der Aufwand und die Kosten im Zusammenhang mit Kühl-, Überwachungs-, Steuerungseinrichtungen, Leitungen und dgl., die zur Kühlung, Steuerung und für den Betrieb des hybriden Leistungsschalters 1 erforderlich sind, werden deutlich reduziert.

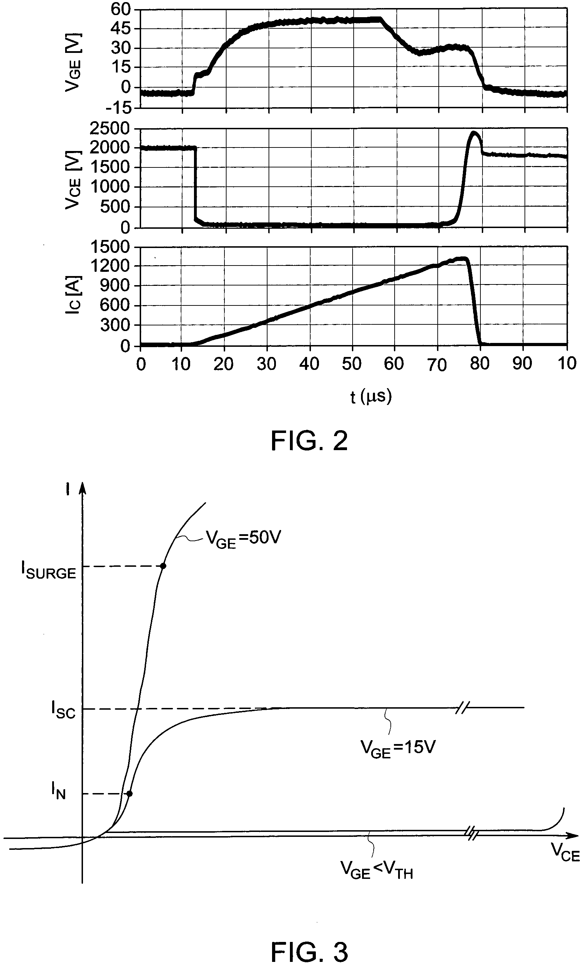

Fig. 2 zeigt gemessene Verläufe der Spannungs- und Stromsignale beim Ein- und Ausschalten eines IGBTs 7, wie er in dem Hauptschalter 6 des hybriden DC-Leistungsschalters 1 nach Fig. 1 verwendet werden kann, entsprechend der erfindungsgemäßen Ansteuerungsweise. Insbesondere ist eine Messung des Abschaltens eines auf den Nennstrom I_{C nom} = 50 A spezifizierten IGBTs bei einem Kollektorstrom I_{C} von 1350 A, also dem 27-fachen Nennstrom gezeigt. Dargestellt sind die Gate-Emitter-Spannung V_{GE}, die Kollektor-Emitter-Spannung V_{CE} und der Kollektorstrom I_{C} über der Zeit t.

Vor dem Einschalten beträgt V_{GE} = -5 V, die Zwischenkreisspannung beträgt 2000 V. Bei t ≈ 12 µs wird eine positive Gatespannung von V_{GE} = 50 V angelegt. Der Strom steigt gemäß der Induktivität der Last an. Bei t = 56 µs wird das Abschaltsignal gesetzt. V_{GE} sinkt auf das Millerplateau, das nun bei dem überhöhten Strom bei etwa 30V erscheint. Der IGBT beginnt nun bei etwa t = 65 µs zu entsättigen. Entsprechend dem noch ansteigenden Strom I_{C} steigt V_{GE} im Miller-Plateau noch etwas an. Der Strom I_{C} steigt gleichermaßen weiter. Schließlich wird ein Strom I_{C} von 1350 A erfolgreich abgeschaltet, was dem 27-fachen Nennstrom des verwendeten 4,5 kV IGBT Chips entspricht. Am Ende des Vorgangs sinkt die Gate-Spannung wieder auf die angelegten -5 V ab.

In gleicher Weise wird die Zerstörungsgrenze des IGBTs während des Betriebes mit erhöhter Gatespannung nach oben verschoben. Fig. 3 zeigt eine Prinzipdarstellung eines Ausgangskennlinienfeldes eines IGBTs, die zeigt, dass der sogenannte "SURGE"-Betrieb (Überlastbetrieb) des IGBTs bei erhöhter Gate-spannung von hier z.B. 50V im Sättigungsbereich liegt. Dementsprechend ist im Hinblick auf die jeweilige Anwendung ein Sicherheitsabstand einzuhalten, der ausreichenden Abstand zur Zerstörungsgrenze im aktiven Bereich vorhält. Unter Berücksichtigung dieser Kriterien ist ein "Surge"-Betrieb für kurzzeitige Überlastfälle mit einem "Surge"-Strom I_{Surge}, der dem 5-bis 25-fachen Nennstrom IN und einem Vielfachen des Kurzschlussstroms I_{SC} entspricht, bei einer Gate-Emitter-Spannung, die deutlich größer ist als die Gate-Emitter-Nennspannung, ermöglicht.

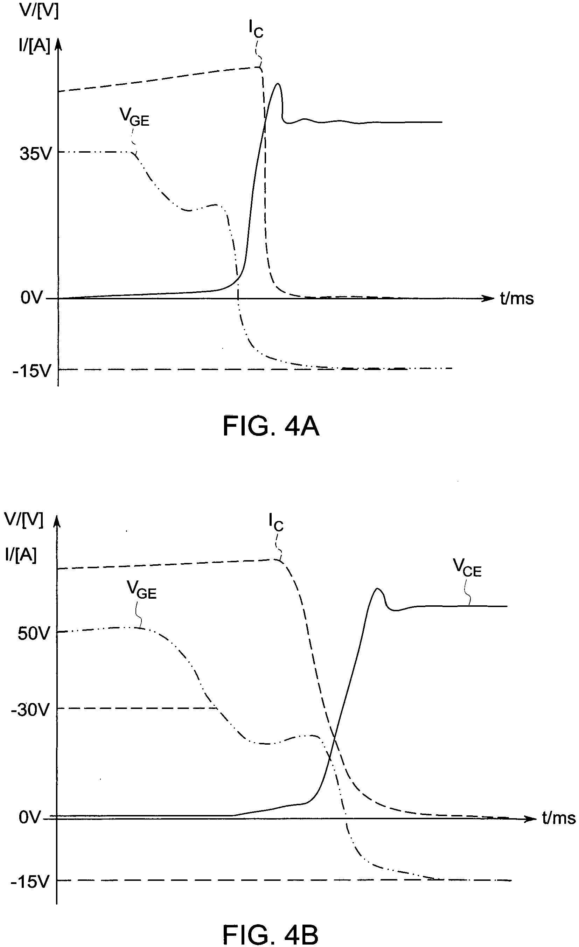

Figuren 4a und 4b zeigen Spannungs- und Stromverläufe ähnlich der Fig. 2, jedoch beschränkt auf die Abschaltung eines IGBTs, zur Veranschaulichung von Weiterbildungen von Ausführungsformen der Erfindung, in stark vereinfachter Darstellung. Fig. 4a zeigt, dass eine über der für den Dauerbetrieb maximal zulässigen Spannung liegende Gate-Emitter-Spannung V_{GE} von bspw. 35V angelegt wird. Dadurch kann bspw. der fünffache Nennbetriebsstrom durch die IGBTs des Hauptschalters 6 des hybriden DC-Leistungsschalters 1 nach Fig. 1 geführt werden. Dennoch kann dieser hohe Strom sicher abgeschaltet werden.

Wie ersichtlich, fällt der Kollektorstrom I_{C} relativ schnell, mit hoher Steilheit ab, wenn die V_{GE} abgeschaltet wird. Ferner ist ersichtlich dass die Kollektor-Emitter-Spannung V_{CE} relativ schnell, mit hoher Steilheit bis zu der Sperrspannung ansteigt. Kurz vor Erreichen der Sperrspannung zeigt V_{CE} eine Abschaltspannungsspitze (Spannungsüberhöhung). Die Abschaltspannungsspitze ist abhängig von der Streuinduktivität und der somit induzierten Spannung an dieser entsprechend dem geschalteten di/dt und der Einschaltspannungsspitze der Diode.

Derartige hohe Kollektorstromsteilheiten di/dt, Kollektorspannungssteilheiten dv/dt und Spannungsüberhöhungen können eventuell den IGBT beschädigen und überhöhte Schaltverluste hervorrufen. Die Ansteuereinheit 18 kann aber gemäß Weiterbildungen der Erfindung eingerichtet sein, um die di/dt- und dv/dt-Verläufe zu optimieren, Überspannungen zu minimieren und Schaltverluste zu reduzieren als auch Ein- und Ausschaltzeiten zu beeinflussen.

In einer bevorzugten Weiterbildung ist die Ansteuereinheit 18 zu diesem Zweck dazu eingerichtet, ein Leistungshalbleiterschaltelement, bspw. die IGBT-Schalter 7 des Hauptschalters 6 des hybriden DC-Leistungsschalters 1 nach Fig. 1, zwischen dem Ein- und dem endgültigen Ausschalten mit einer Ansteuerungsspannung auf wenigstens einem Zwischenniveau anzusteuern, das unterhalb desjenigen der erhöhten Ansteuerungsspannung während des eingeschalteten Zustands, jedoch oberhalb der für den Dauerbetrieb spezifizierten maximal zulässigen Ansteuerungsspannung liegt. Bspw. veranschaulicht Fig. 4b einen vorteilhaften Abschaltvorgang für einen IGBT bspw. des Hauptschalters 6, bei dem zunächst die erhöhte Gate-Emitter-Spannung V_{GE} von 50V anliegt und anschließend auf eine erhöhte Gatespannung oberhalb von 20V, hier z.B. 30 V, geschaltet wird, bevor schließlich eine Spannung von -5V an das Gate geschaltet wird, um den Schalter endgültig abzuschalten. Das gestufte Schalten der Gatespannung ermöglicht ferner eine Reduktion der Kollektorstromänderungsgeschwindigkeit di/dt als auch des Spannungsanstieges d*v_{CE}*/d*t*. Wie an dem leicht ansteigenden Verlauf von V_{CE} kurz vor deren steilerem Anstieg ersichtlich, bewirkt die Zwischenstufe bei 30V ferner, dass der IGBT stärker entsättigt, wodurch sowohl der IGBT-Kollektorstrom als auch die Abschaltspannungsspitze von V_{CE} begrenzt wird. Das Vorsehen ein oder mehrerer Zwischenstufen für die Gatespannung V_{GE} unterstützt es, auch sehr hohe Ströme, bis zum Zehnfachen des Nennbetriebsstroms, sicher abzuschalten.

Es können noch weitere Maßnahmen aufgenommen werden, um das sichere Ausschalten eines IGBTs, und somit bspw. des Hauptschalters 6 in Fig. 1, auch bei sehr hohen Kollektorströmen zu unterstützen. Bspw. können verschiedene Treiberstufen für die Ansteuerung des Gates sowohl für das Ein- als auch das Ausschalten mit unterschiedlichen Gate-Widerständen zur Verfügung gestellt werden, die in Abhängigkeit von dem Laststrom, der Spannung und der Temperatur individuell gewählt werden können, um kritische Betriebszustände, wie Überspannungen, Überströme und Oszillationen zu vermeiden, die Schaltvorgänge zeitabhängig zu optimieren und die Schaltverluste zu reduzieren. Ferner kann eine Überspannungsbegrenzung (sog. Active Clamping) eingesetzt werden, um die Kollektorstromänderungsgeschwindigkeit di/dt und auch den Maximalwert der Kollektor-Emitter-Spannung durch eine Rückkopplung der Kollektor-Emitter-Spannung auf den Steuereingang des IGBTs während des Ausschaltvorgangs zu reduzieren. Ferner kann die Kollektorstromänderungsgeschwindigkeit di/dt aktiv gesteuert bzw. reduziert werden, um bspw. die Belastung der Freilaufdiode zu reduzieren. Ebenso kann die Kollektor-Emitter-Spannungs-Änderungsgeschwindigkeit gesteuert bzw. reduziert werden. Es kann ein sanftes Abschalten durch eine auch kontinuierliche Reduktion der Gate-Emitter-Spannung V_{GE} bewerkstelligt werden.

Vorteilhafterweise kann die zu wählende Ansteuerspannung bzw. Gate-Emitter-Spannung V_{GE} in Abhängigkeit von der vorgebbaren Lebensdauer und den geschätzten Betriebsparametern passend gewählt werden. Es ist bekannt, dass die Lebensdauer bis zum Durchbruch der Gateoxidschicht von der Feldstärke an der Oxidschicht, der Temperatur der Oxidschicht, der Halbleiterfläche und der Änderung der Enthalpie von einem stabilen Zustand zu einem aktivierten Übergangszustand für den Durchbruch abhängig ist. Dabei entspricht die Feldstärke an der Oxidschicht dem Quotienten aus der angelegten Gatespannung V_{GE} und der Oxiddicke der Gateoxidschicht. Berechnungen und Simulationen haben gezeigt, dass eine Verdopplung der Gatespannung von üblicherweise 15V auf 30V die Lebensdauer um etwa den Faktor 300 verringert. Im Übrigen scheint die Abhängigkeit der Lebensdauer der Gateoxidschicht bis zum Durchbruch von der Gate-Emitter-Spannung exponentiell zu sein. Somit kann die Höhe der erhöhten Ansteuerspannung bzw. Gate-Emitter-Spannung V_{GE} in Abhängigkeit von einer vorgegebenen gesamten Lebensdauer bis zum Durchbruch der Gateoxidschicht zwischen dem Gate G und dem Emitter E der Leistungshalbleiterschaltelemente 7 unter Schätzung einer erwarteten gesamten Einschaltdauer der Leistungshalbleiterschaltelemente 7 als die Summe der geschätzten Einschaltdauern aller erwarteten Einschaltvorgänge und unter Berücksichtigung einer aufgrund der erwarteten Einschaltvorgänge geschätzten Reduktion der Lebensdauer derart gewählt werden, dass die vorgegebene Lebensdauer mit hoher Wahrscheinlichkeit erreicht werden kann, ohne dass es zu einer Zerstörung der Leistungshalbleiterschaltelemente 7 kommt. Es kann unter Berücksichtigung der gegebenen bzw. vorgesehenen Betriebsbedingungen abgeschätzt werden, ob bei der gegebenen Anwendung eine weitere Erhöhung der Gate-Emitter-Spannung, z.B. auf +50V oder sogar darüber hinaus, möglich ist.

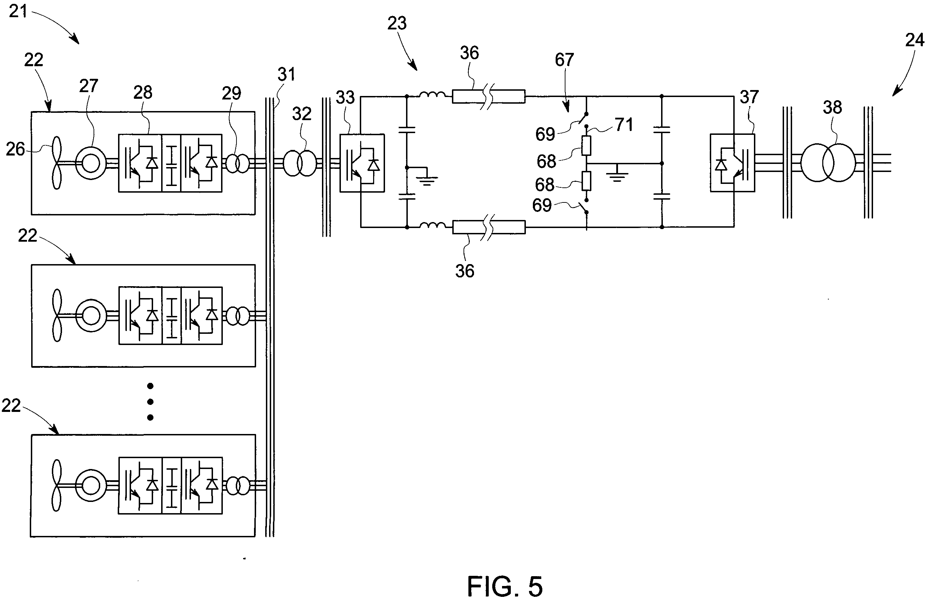

Fig. 5 zeigt eine weitere Ausführungsform, in der die Erfindung wirkungsvoll eingesetzt werden kann. Es ist ein Windpark 21 mit mehreren Windkraftanlagen 22 zur Energieerzeugung und ein Hochspannungsgleichstromübertragungs(HGÜ)-System 23 veranschaulicht, das dazu dient, die von dem Windpark 21 gelieferte Energie zu einem nachgeschalteten Wechselspannungsnetz 24, bspw. einem Energieverteilungsnetz oder einem öffentlichen Versorgungsnetz, zu übertragen. Wie allgemein bekannt ist, weist jede Windkraftanlage 22 Rotorblätter 26 auf, die die kinetische Energie des Windes in eine mechanische Energie einer rotierenden Welle wandeln, die mit einem Generator 27 verbunden ist. Der Generator 27 wandelt die mechanische Energie der Welle in elektrische Energie um, die dann mit Hilfe einer Leistungselektronik, z.B. eines Vollumrichters oder Frequenzumrichters 28, und eines nachgeschalteten Transformators 29 in eine geeignete Spannung und einen geeigneten Strom zur Einspeisung in eine gemeinsame Sammelschiene 31 der Windkraftanlagen 22 umgesetzt wird. Die Sammelschienenspannung, die bspw. 33 kV betragen kann, kann dann mittels eines Stromrichtertransformators auf bspw. ±150 kV zur Übertragung über das HGÜ-System 23 herauftransformiert werden.

Das HGÜ-System 23 weist im Wesentlichen einen Gleichrichter 33 auf, der die dreiphasige Wechselspannung des Stromrichtertransformators 32 in eine Gleichspannung wandelt, die über Gleichspannungsleitungen 36 des HGÜ-Systems 23 übertragen wird. Bspw. können die Leitungen 36 Gleichspannungen von 300 kV oder mehr über Entfernungen, die hunderte Kilometer betragen können, übertragen.

Die übertragene Leistung auf der Gleichspannungsseite, die eine Hochspannung ist, wird durch einen Wechselrichter 37 in eine Wechselspannung, die eine Hochspannung von bspw. 150 kV ist, umgewandelt, die über einen Stromrichtertransformator 38 in eine passende Spannung des nachgeschalteten Wechselspannungsnetzes 24 transformiert werden kann.

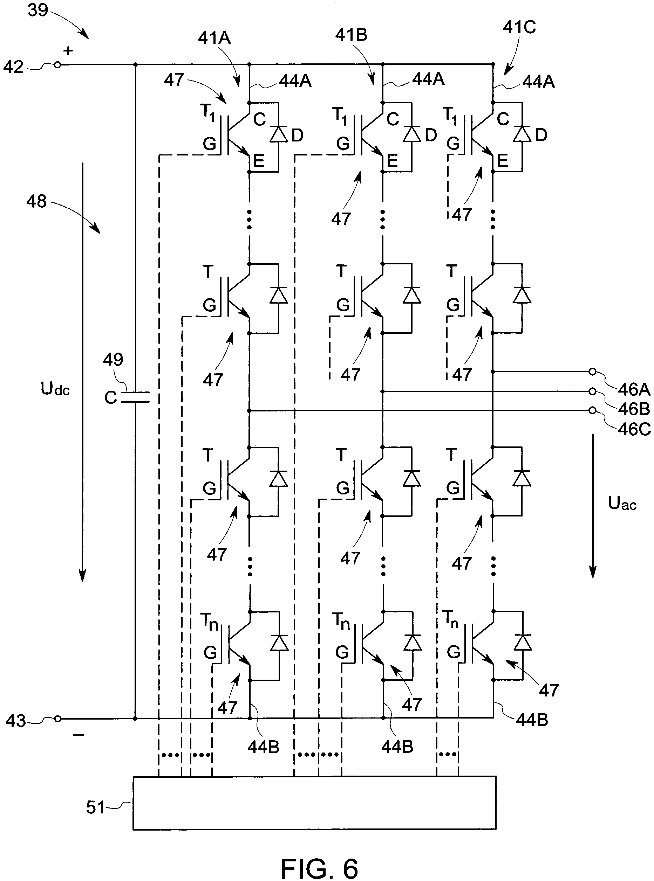

Der Gleichrichter 33 und der Wechselrichter 37 sind Stromrichter, die hier für hohe Leistungen ausgelegt werden müssen. Hierzu sind vielfältige Stromrichtertopologien bekannt. Eine beispielhafte Topologie eines hierzu geeigneten Stromrichters 39 ist in Fig. 6 gezeigt.

Der Stromrichter 39 weist hier drei Phasenzweige 41a, 41b, 41c auf, die sich zwischen einer positiven Stromschiene bzw. einem positiven Gleichspannungsanschluss ("+") 42 des Stromrichters 39 und einer negativen Stromschiene bzw. einem negativen Gleichspannungsanschluss ("-") 43 erstrecken. Wenngleich hier drei Phasenzweige 41a-c veranschaulicht sind, ist verständlich, dass je nach Anzahl der Phasen in der jeweiligen Anwendung bzw. Schaltungsumgebung auch nur ein einziger Phasenzweig 41 oder zwei oder mehr als drei Phasenzweige vorhanden sein können.

Jeder Phasenzweig 41a-c weist einen ersten, in Fig. 6 oberen Zweigarm, 44a und einen damit verbundenen zweiten, unteren Zweigarm 44b auf, die an einem Verbindungspunkt miteinander verbunden sind, der den jeweiligen Wechselspannungsanschluss 46a, 46b bzw. 46c des jeweiligen Phasenzweiges 41a, 41b bzw. 41c definiert. In jedem Zweigarm 44a, 44b jedes Phasenzweigs 41a-c ist jeweils eine Reihenschaltung mehrerer Leistungshalbleiterschaltelemente 47 (T₁...Tₙ) angeordnet, die gemeinsam für die jeweiligen Betriebsspannungen und Ströme ausgelegt sind.

Parallel zu den Phasenzweigen 41a-c ist ein Gleichspannungszwischenkreis 48 vorgesehen, der hier beispielhaft durch einen Gleichspannungskondensator C, 49 gebildet ist, der zwischen den Gleichspannungsanschlüssen 42, 43 angeschlossen ist.

Wie veranschaulicht, sind die Leistungshalbleiterschaltelemente 47 vorteilhafterweise durch IGBTs gebildet, die von einer Ansteuereinheit 51 nach einem bestimmten Pulsmuster gemäß einem vorbestimmten Modulationsverfahren, bspw. durch Pulsweitenmodulation (PWM), angesteuert werden, um die Gleichspannung V_{dc} am Gleichspannungszwischenkreis 48 in eine hier dreiphasige Wechselspannung v_{ac} an den Wechselspannungsanschlüssen 46a-c oder umgekehrt zu wandeln. Mit einer Vielzahl von IGBTs pro Zweigarm 44a,b kann der Stromrichter 39 mit hinreichender Sperrfähigkeit beschaffen sein.

Gemäß der Erfindung ist die Ansteuereinheit 51 hier dazu eingerichtet, die Leistungshalbleiterschaltelemente 47 der jeweiligen Reihenschaltungen in den jeweiligen Zweigarmen 44a, b der jeweiligen Phasenzweige 41a-c jeweils mit einer Gate-Emitter-Spannung anzusteuern, die oberhalb der spezifizierten maximal zulässigen Ansteuerspannung für die Leistungshalbleiterschaltelemente 47 (Gate-Emitter-Spannung für IGBTs) liegt. Bei einer maximal zulässigen Gate-Emitter-Spannung von 20V kann die Ansteuereinheit 51 hier in ähnlicher Weise, wie bei der Ausführungsform nach Fig. 1, eine Gate-Emitter-Spannung von bspw. 30V oder, wenn dies die Lebensdauer zulässt, von 50V anlegen, um höhere Kollektor- bzw. Zweigarmströme zu ermöglichen, die größer als der doppelte Nennbetriebsstrom sind und sogar das Fünf- bis Zehnfache von diesem betragen können. Auf diese Weise kann derselbe Stromrichter für deutlich höhere Leistungen verwendet werden, oder umgekehrt kann für eine gegebene Nennbetriebsleistung die Anzahl der Leistungshalbleiterschaltelemente 47 und die damit verbundene Halbleiterfläche reduziert werden. Infolgedessen können Implementierungs- und Betriebskosten für den Stromrichter 39 und das System, in dem dieser eingesetzt, wie bspw. das HGÜ-System 23 nach Fig. 5, gesenkt werden.

Wenngleich in Fig. 5 ein HGÜ-System 23 zur Kopplung des Windparks 21 mit dem Netz 24 veranschaulicht ist, kann auch ein MV-DC-System zur Kopplung von Windkraft- oder Photovoltaikanlagen oder von Antrieben erfindungsgemäß eingesetzt werden. Außerdem ist der verwendete Stromrichter nicht auf die in Fig. 6 speziell gezeigte Stromrichterbauart beschränkt. Vielmehr sind vielfältige Topologien von zwei oder mehrstufigen Stromrichtern verwendbar.

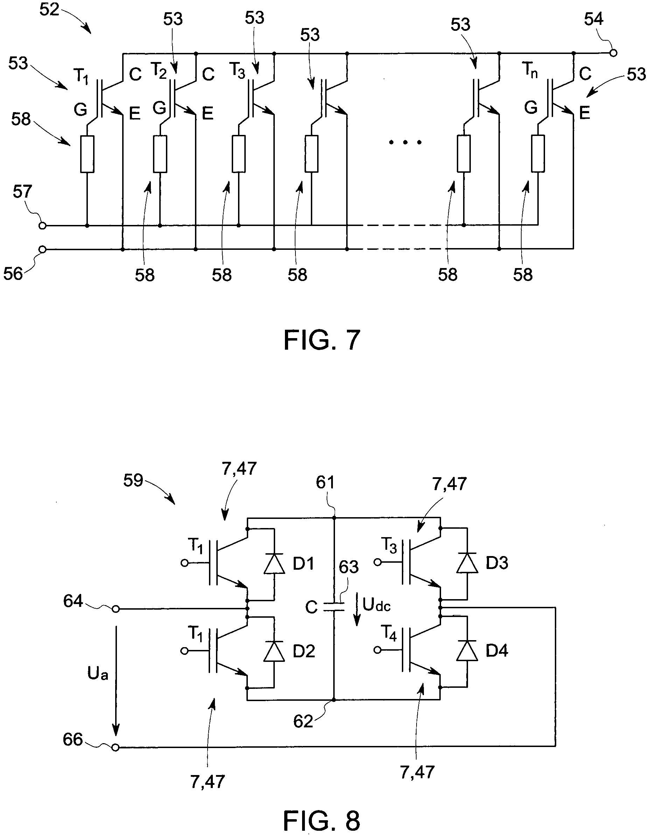

Fig. 7 zeigt eine mögliche Modifikation, die auf den Stromrichter nach Fig. 6 angewandt werden kann und die eine vorteilhafte Ausnutzung der erfindungsgemäßen Maßnahme der Erhöhung der Gate-Emitter-Spannung über den zulässigen Bereich hinaus ermöglicht. Fig. 7 veranschaulicht ein Leistungshalbleitermodul 52, das eine Reihenschaltung aus Leistungshalbleiterschaltelementen 47 (T₁...Tₙ) in einem jeweiligen Zweigarm 44a bzw. 44b eines jeden Phasenzweigs 41a-c ersetzen kann. Das Leistungshalbleitermodul 52 weist eine Parallelschaltung aus Leistungshalbleiterschaltelementen 53 (T₁...Tₙ) auf, die parallel zueinander zwischen einem ersten Anschluss 54, mit dem sämtliche Kollektoren C der Leistungshalbleiterschaltelemente 53 verbunden sind, einem zweiten Anschluss 56, mit dem sämtliche Emitter E der Leistungshalbleiterschaltelemente 53 verbunden sind, und einem gemeinsamen Steuer- bzw. Gateanschluss 57 angeschlossen sind. Das Leistungshalbleitermodul 52 kann eine beliebige Anzahl von wenigstens zwei zueinander parallel angeordneten IGBTs T₁...Tₙ aufweisen.

Wie ferner aus Fig. 7 hervorgeht, kann zwischen der Gate-Elektrode G eines jeden IGBTs T₁...Tₙ und dem gemeinsamen Steuer- bzw. Gateanschluss 57 jeweils ein Gate-Vorwiderstand angeordnet sein. Diese Widerstände 58 können zur Symmetrierung der Schaltung verwendet werden, um zu bewirken, dass alle IGBTs T₁...Tₙ durch die Ansteuereinheit 51 möglichst gleichzeitig und gleichmäßig geschaltet werden können. Die Gate-Vorwiderstände können gemeinsam mit den IGBTs T₁...Tₙ, 53 auf den Halbleiterchips oder auch außerhalb dieser Chips angeordnet sein.

Wie vorstehend erwähnt, kann das Leistungshalbleitermodul 52 eine jeweilige Reihenschaltung der mehreren Leistungshalbleiterschaltelemente 47 der jeweiligen Zweigarme 44a bzw. 44b ersetzen. Damit wird die Reihenschaltung der IBGTs durch eine Parallelschaltung ersetzt, wodurch jeder Zweigarm 44a, b des Stromrichters 39 nun für einen größeren Strom ausgelegt wird. Vorteilhafterweise kann durch die Erhöhung der Gate-Emitter-Spannung V_{GE} über die maximal zulässige Gate-Emitter-Spannung nach der Spezifikation hinaus jeder der IGBTs T₁...Tₙ, 53 in Fig. 7 kurzzeitig mit einem erhöhten Strom belastet werden, der dem zwei- oder mehrfachen, bis zu zehnfachen Nennstrom entsprechen kann. Somit kann der Stromrichter für noch höhere Leistungen ausgelegt werden, oder umgekehrt können bei einer gegebenen Leistung die Anzahl der parallel geschalteten IGBTs T₁...Tₙ, 53 und die damit verbundene Halbleiterchipfläche reduziert werden, was die Implementierungs- und Betriebskosten senkt.

In einer noch weiteren optionalen Modifikation kann die Parallelschaltung der IGBTs T₁...Tₙ nach Fig. 7 jeweils einen einzelnen der Leistungshalbleiterschaltelemente 47 in Fig. 6 ersetzen. Damit weist jeder Zweigarm 44a bzw. 44b eine Reihenschaltung aus jeweils mehreren parallel geschalteten IGBTs auf. Ein derartiger Stromrichter 39 ist für sehr hohe Lastströme und sehr hohe Spannungen geeignet, wobei die erfindungsgemäße Ansteuerung hier zur Platz-, Aufwand- und Kostenreduktion besonders effektiv eingesetzt werden kann.

Fig. 8 zeigt ein bidirektionales Submodul 59, das als weitere Option in dem Stromrichter 39 nach Fig. 6 eingesetzt werden kann, um einen modularen mehrstufigen Stromrichter zu schaffen. Das Submodul 59 weist eine Vollbrückenkonfiguration mit einer Reihenschaltung von IGBTs T₁, T₂ (53) mit jeweils antiparallelen Freilaufdioden D1, D2 und einer zweiten Reihenschaltung von IGBTs T₃, T₄ (53) mit zugehörigen antiparallelen Freilaufdioden D3, D4 auf, wobei beide Reihenschaltungen zwischen einem ersten Gleichspannungsknoten 61 und einem zweiten Gleichspannungsknoten 62 zueinander angeschlossen sind. Ferner ist ein als Energiespeicher 63 dienender Kondensator C parallel zu den beiden Reihenschaltungen geschaltet. Die Verbindungspunkte zwischen den IGBTs T₁, T₂ bzw. T₃, T₄ der jeweiligen Reihenschaltungen bilden einen ersten und zweiten Wechselspannungsanschluss 64 bzw. 66.

Die Gleichspannung v_{dc} an dem Kondensator C ist aufgrund der Beschaltung der Freilaufdioden D1-D4 stets positiv und kann je nach Bemessung und Anwendung bspw. zwischen einigen hundert Volt und einigen kV betragen. Die Anschlussspannung v_{ac} zwischen den AC-Anschlüssen 64, 66 des Submoduls 59 kann im Wesentlichen die Werte -v_{dc}, +v_{dc} oder 0 annehmen. Die Gleichspannung v_{dc} an dem Kondensator C kann wie bereits beschrieben, größer oder kleiner werden. Ein Strom kann durch das Submodul 59 prinzipiell in beide Richtungen fließen.

Das Submodul 59 kann jedes der Leistungshalbleiterschaltelemente 47 in dem Stromrichter 39 nach Fig. 6 ersetzen, wodurch ein modularer Mehrpunktstromrichter geschaffen wird. Durch die modulare Bauweise ist der Stromrichter für unterschiedliche Leistungen und Anwendungen individuell skalierbar. Die Spannungen und Ströme auf der AC- und der DC-Seite können hochdynamisch und weitgehend entkoppelt voneinander gesteuert und geregelt werden. Vorteilhafterweise können auch hier durch kurzzeitige Ansteuerung mit einer erhöhten Gate-Emitter-Spannung, die über die maximal zulässige Gate-Emitter-Spannung der IGBTs hinausgeht, die Leistungen noch weiter erhöht werden. Umgekehrt kann bei gleicher Leistung die Halbleiterfläche und Baugröße des Stromrichters 39 reduziert werden, was die Vorteile einer Reduktion des Aufwands und der damit verbundenen Kosten für die Implementierung und den Betrieb des Stromrichters 39 ermöglicht. Um Wiederholungen zu vermeiden, wird auf die vorstehenden Ausführungen im Zusammenhang mit dem hybriden DC-Leistungsschalter nach Fig. 1 verwiesen, wobei der Stromrichter 39 nach Fig. 6, der einen beliebigen Gleichrichter (z.B. 33 in Fig. 5), Wechselrichter (z.B. 37 in Fig. 5) oder Frequenzumrichter (z.B. 28 in Fig. 5) repräsentiert, hier eine Einrichtung 2 zur bedarfsweisen kurzzeitigen Übernahme eines elektrischen Stroms im Sinne der Erfindung bildet.

Es sollte ferner beachtet werden, dass der Stromrichter nach Fig. 6 mit der erfindungsgemäßen Maßnahme der erhöhten Gate-Emitter-Spannung prinzipiell nur in Anwendungen verwendet werden sollte, in denen er nur relativ selten oder so kurzzeitig eingesetzt wird, dass die Zeitdauer bis zum Durchbruch der Gateoxidschicht der IGBTs die gewünschte Lebensdauer nicht überschreitet. Der Stromrichter ist aber für zahlreiche Antriebssysteme, die nur kurzzeitig und/oder selten eingesetzt werden, geeignet. Die erforderliche Halbleiterfläche, die Baugröße des Stromrichters 39 und dessen Gewicht können durch die Erfindung deutlich reduziert werden, was für viele Anwendungen äußerst nützlich ist.

Aus Fig. 5 ist noch eine weitere erfindungsgemäße Anwendung für den Stromrichter 39 ersichtlich. Fig. 5 veranschaulicht eine sog. Chopper-Widerstands-Einrichtung 67, die zwischen den Gleichspannungsleitungen 36 geschaltet ist. Die Chopper-Widerstands-Einrichtung 67 dient zum Schutz gegen Überspannung der Zwischenkreiskapazität des Wechselrichters 37. Hierzu weist die Chopper-Widerstands-Einrichtung 67 eine Reihenschaltung aus wenigstens einem Widerstand 68 und einem elektronischen Schalter 69 auf, die in einem Leitungszweig 71 parallel zu dem Wechselrichter 37 angeordnet sind. Im vorliegenden Fall sind zwei derartige Paare aus dem Widerstand 68 und dem elektronischen Schalter 69 symmetrisch zu einem geerdeten Mittelpunkt zwischen den Gleichspannungsleitungen 36 des HGÜ-Systems 23 angeordnet. Im Falle eines Fehlers in dem Wechselspannungsnetz 24 werden die Schalter 69 pulsartig, evtl. wiederholt angesteuert, um überschüssige Energie abzuführen bzw. in den Widerständen 68 zu verbrauchen und somit einen Gleichspannungsanstieg in dem Zwischenkreis des Wechselrichters 37 auf sichere Pegel zu begrenzen.

Jeder in Fig. 5 nur symbolhaft dargestellte elektronische Schalter 69 ist vorzugsweise durch eine Reihenschaltung von Leistungshalbleiterschaltelementen, bspw. ähnlich den Schaltelementen 7 bzw. 47 in dem elektronischen Hauptschalter 6 des hybriden DC-Leistungsschalters 1 nach Fig. 1 bzw. in dem Stromrichter 39 nach Fig. 6, ausgebildet. Dadurch kann der elektronische Schalter 69 mit der erforderlichen Sperrfähigkeit insbesondere für HGÜ-Anwendungen beschaffen sein. Durch die erfindungsgemäße Maßnahme der Erhöhung der Ansteuerungs- bzw. Gate-Emitter-Spannung V_{GE} für die einzelnen Leistungshalbleiterschaltelemente 7 bzw. 47 des Schalters 69 kann hier die erforderliche Halbleiterfläche und die Baugröße der Chopper-Widerstands-Einrichtung 67 deutlich reduziert werden. Eine derartige Chopper-Widerstands-Einrichtung 67 für HGÜ-Anwendungen, wie bspw. für das HGÜ-System 23 nach Fig. 5, kann eine enorme Größe erreichen. Vorteilhafterweise kann diese Baugröße durch die Erfindung auf einen Bruchteil, bspw. die Hälfte oder noch weniger, der normalen Größe reduziert werden.

Es sollte beachtet werden, dass die Chopper-Widerstands-Einrichtung 67 nicht auf die Anwendung bei HGÜ-Systemen beschränkt ist. Sie kann z.B. auch als Bremschopper in Antriebssystemen verwendet werden, um im Bremsfall überschüssige Energie, die in Form eines generatorischen Stroms vom Motor zurück in den Zwischenkreis fließt, über den angeschlossenen Bremswiderstand in thermische Energie umzuwandeln. Der elektronische Schalter, bspw. 69, schaltet dann den angeschlossenen Widerstand, bspw. 68, ein, bevor die Zwischenkreisspannung eine für die Komponenten unzulässige Höhe erreicht. Sobald die Zwischenkreisspannung wieder abnimmt und kleiner als die Einschaltspannung wird, aber größer als die Netzspannung ist, schaltet der Schalter 69 den Widerstand 68 wieder ab. Der Vorgang wiederholt sich, sobald die Spannung wieder ansteigt. Auch derartige Bremschopper werden relativ kurzzeitig und/oder selten verwendet, so dass die erfindungsgemäße Maßnahme der Erhöhung der Ansteuerungsspannung über zulässige Grenzen hinaus hier vorteilhafterweise eingesetzt werden kann.

Ein Fachmann wird erkennen, dass außer den dargestellten beispielhaften und besonders bevorzugten Anwendungsfällen weitere Anwendungen für die Erfindung erkennbar sind, bei denen eine Reihen- und/oder Parallelschaltung von Leistungshalbleiterschaltelementen im normalen Betrieb relativ kurzzeitig und/oder selten und/oder pulsartig angesteuert wird, so dass die erfindungsgemäße Verwendung zur Spannungssenkung ermöglicht ist.

Es ist eine Einrichtung 2 zur bedarfsweisen Kommutierung eines elektrischen Stroms von einem ersten Leitungszweig 14, 3; 36 zu einem anderen, zweiten Leitungszweig 4; 41; 71 geschaffen, die mehrere Leistungshalbleiterschaltelemente 7; 47; 53, die in Reihe und/oder parallel zueinander in dem zweiten Leitungszweig 4; 41; 71 angeordnet sind, und eine Ansteuereinheit 18; 51 zur Ansteuerung der mehreren Leistungshalbleiterschaltelemente 7; 47; 53 aufweist. Die Ansteuereinheit 18; 51 ist dazu eingerichtet, an die mehreren Leistungshalbleiterschaltelemente 7; 47; 53 jeweils eine erhöhte Ansteuerungsspannung V_{GE} anzulegen, deren Höhe oberhalb der für den Dauerbetrieb spezifizierten maximal zulässigen Ansteuerungsspannung liegt, um die mehreren Leistungshalbleiterschaltelemente leitend zu schalten oder zu halten und einen erhöhten Stromfluss durch diese zu bewirken, dessen Stromstärke wenigstens dem doppelten Nennbetriebsstrom entspricht. Die Ansteuereinheit 18; 51 ist ferner dazu eingerichtet, die mehreren Leistungshalbleiterschaltelemente nach einer jeweils vorgesehenen kurzen Einschaltdauer durch Abschalten der Ansteuerungsspannung V_{GE} wieder auszuschalten, während sie einen erhöhten Stromfluss führen. Die Einrichtung 2 kann dadurch für eine höhere Leistung im Betrieb ausgelegt werden, oder bei einer gegebenen Betriebsleistung kann die Halbleiterfläche und Baugröße der Einrichtung 2 reduziert werden.

## Patentansprüche

1. Einrichtung zur bedarfsweisen kurzzeitigen Übernahme eines elektrischen Stroms von einer Energieübertragungs- oder -verteilungsvorrichtung (14; 36)
mit wenigstens einem Leitungszweig (3; 41; 71), der mit der Energieübertragungs- oder -verteilungsvorrichtung (14; 36) verbunden ist,
mit mehreren Leistungshalbleiterschaltelementen (7; 47; 53), die in Reihe und/oder parallel zueinander in dem wenigstens einen Leitungszweig (3; 41; 71) angeordnet sind, und
mit einer Ansteuereinheit (18, 51) zur Ansteuerung der mehreren Leitungshalbleiterschaltelemente (7; 47; 53), wobei die Ansteuereinheit (18, 51) eingerichtet ist, um an die mehreren Leistungshalbleiterschaltelemente (7; 47; 53) jeweils eine erhöhte Ansteuerungsspannung (V_{GE}), deren Höhe oberhalb der für den Dauerbetrieb spezifizierten maximal zulässigen Ansteuerungsspannung liegt, anzulegen, um die mehreren Leistungshalbleiterschaltelemente (7; 47; 53) einzuschalten und einen erhöhten Stromfluss durch diese zu bewirken, dessen Stromstärke wenigstens dem doppelten Nennbetriebsstrom entspricht, und wobei die Ansteuereinheit (18, 51) ferner dazu eingerichtet ist, die mehreren Leistungshalbleiterschaltelemente (7; 47; 53) durch Abschalten der Ansteuerungsspannung (V_{GE}) wieder auszuschalten, während sie einen erhöhten Stromfluss führen.

2. Einrichtung nach Anspruch 1, wobei die positive Ansteuerspannung so gewählt ist, dass sie kurzeitig mehr als das 1,5-fache, bis zu dem 4-fachen oder sogar darüber, der vom Hersteller maximal zulässigen Ansteuerspannung beträgt.

3. Einrichtung nach Anspruch 1 oder 2, wobei die abzuschaltende Stromstärke über dem bei empfohlener positiver Ansteuerungsspannung (V_{GE}) gegebenen Kurzschlussstrom (I_{SC}) liegt und bis zum 27-fachen oder mehr des spezifizierten Nominalstroms (I_{C nom}) beträgt.

4. Einrichtung nach einem beliebigen der vorhergehenden Ansprüche, **dadurch gekennzeichnet, dass** die Energieübertragungs- oder -verteilungsvorrichtung (14, 36) eine Hochspannungsgleichstromübertragungs(HGÜ)-Leitung ist und/oder jedes der mehreren Leistungshalbleiterschaltelemente (7; 47; 53) durch einen IGBT gebildet ist.

5. Einrichtung nach einem beliebigen der vorhergehenden Ansprüche, **dadurch gekennzeichnet, dass** sie ein Teil eines hybriden Gleichstrom(DC)-Leistungsschalters (1) ist, der einen zu der Energieübertragungs- oder -verteilungsvorrichtung (14) in Reihe geschalteten Hauptstromzweig (3), der eine Reihenschaltung aus einem elektronischen Hilfsschalter (11) und einem schnellen mechanischen Trennschalter (12) aufweist, und einen Bypasszweig (4) aufweist, der parallel zu dem Hauptstromzweig (3) angeschlossen ist und einen elektronischen Hauptschalter (6) enthält, der die mehreren Leistungshalbleiterschaltelemente (7) aufweist.

6. Einrichtung nach Anspruch 5, **dadurch gekennzeichnet, dass** der elektronische Hilfsschalter (11) ein oder mehrere in Reihe geschaltete Leistungshalbleiterschaltelemente (13) aufweist, die insgesamt für eine geringere Nennleistung und für geringere Leitungsverluste eingerichtet sind als die Reihen- und/oder Parallelschaltung der mehreren Leistungshalbleiterschaltelemente (7) des elektronischen Hauptschalters (6).

7. Einrichtung nach Anspruch 5 oder 6, **dadurch gekennzeichnet, dass** der elektronische Hauptschalter (6) eine Reihenschaltung aus wenigstens 2 oder mehreren, für Hochspannungsanwendungen aus wenigstens 10 oder zig Leistungshalbleiterschaltelementen (7) aufweist.

8. Einrichtung nach einem beliebigen der Ansprüche 5-7, **dadurch gekennzeichnet, dass** im normalen Betrieb der elektronische Hilfsschalter (11) leitend geschaltet ist, der schnelle mechanische Trennschalter (12) geschlossen ist und der Strom durch den Hauptstromzweig (3) fließt und im Falle der Erkennung eines Fehlers in der Energieübertragungs- oder -verteilungsvorrichtung (14) zuerst der elektronische Hilfsschalter (11) geöffnet wird und die mehreren Leistungshalbleiterschaltelemente (7) des elektronischen Hauptschalters (6) mit der erhöhten Ansteuerungsspannung (V_{GE}) angesteuert werden, um den Strom auf den Bypasszweig (4) zu kommutieren, anschließend der schnelle mechanische Schalter (12) geöffnet wird und dann der elektronische Hauptschalter (6) geöffnet wird, um den erhöhten Stromfluss in dem Bypasszweig (4) zu unterbrechen.

9. Einrichtung nach einem beliebigen der Ansprüche 1-4, **dadurch gekennzeichnet, dass** sie ein Teil eines Stromrichters (33, 37; 39) ist, der einen oder mehrere zueinander parallel geschaltete Zweige (41a-c) aufweist, wobei jeder Zweig (41a-c) wenigstens zwei in Reihe geschaltete elektronische Schalter (47; 52; 59) aufweist, die von der Ansteuereinheit (51) gemäß einem bestimmten Pulsmuster angesteuert werden, um eine erste Leistung mit ersten Strom- und Spannungseigenschaften in eine zweite Leistung mit zweiten Strom- und Spannungseigenschaften umzuwandeln.

10. Einrichtung nach Anspruch 9, **dadurch gekennzeichnet, dass** die wenigstens zwei in Reihe geschalteten elektronischen Schalter (47; 52; 59) jeweils mehrere in Reihe und/oder parallel geschaltete Leistungshalbleiterschaltelemente (47; 53) aufweisen, die im Normalbetrieb des Stromrichters mit der erhöhten Ansteuerungsspannung (V_{GE}) gemäß dem bestimmten Pulsmuster angesteuert werden.

11. Einrichtung nach Anspruch 9 oder 10, **dadurch gekennzeichnet, dass** der Stromrichter (33, 37; 39) eine Chopper-Widerstands-Einrichtung (67) zum Schutz gegen Überspannung in einem Gleichspannungszwischenkreis (48) des Stromrichters (33, 37; 39) aufweist, wobei die Chopper-Widerstands-Einrichtung (67) parallel zu dem einen oder den mehreren parallelen Zweigen (41a-c) des Stromrichters angeschlossen ist und eine Reihenschaltung aus wenigstens einem Widerstand (68) und einem elektronischen Schalter (69) aufweist, wobei der elektronische Schalter (69) durch die mehreren in Reihe oder parallel geschalteten Leistungshalbleiterschaltelemente (7; 47) gebildet ist, die, wenn die Spannung in dem Gleichspannungszwischenkreis (48) eine vorgegebene Schwellspannung übersteigt, für kurze Zeit, pulsartig, gegebenenfalls wiederholt mit der erhöhten Ansteuerungsspannung (V_{GE}) angesteuert werden.

12. Einrichtung nach einem beliebigen der vorhergehenden Ansprüche, **dadurch gekennzeichnet, dass** die Ansteuereinheit (18; 51) dazu eingerichtet ist, die mehreren Leistungshalbleiterschaltelemente (7; 47; 53) zwischen dem Ein- und dem endgültigen Ausschalten mit einer Ansteuerungsspannung (V_{GE}) auf wenigstens einem Zwischenniveau anzusteuern, das unterhalb desjenigen der erhöhten Ansteuerungsspannung beim Einschalten, jedoch oberhalb der für den Dauerbetrieb spezifizierten maximal zulässigen Ansteuerungsspannung liegt.

13. Verwendung einer Reihen- und/oder Parallelschaltung mehrerer Leistungshalbleiterschaltelemente (7; 47; 53), insbesondere IGBTs, in einer Einrichtung (1; 39; 67) zur bedarfsweisen kurzzeitigen Übernahme eines Stroms von einer Energieübertragungs- oder -verteilungsvorrichtung (14; 36) mit wenigstens einem Leitungszweig (3; 41; 71), der mit der Energieübertragungs- oder -verteilungsvorrichtung (14; 36) verbunden ist und in dem die Reihen- und/oder Parallelschaltung der mehreren Leistungshalbleiterschaltelemente (7; 47; 53) angeordnet ist, wobei die mehreren Leistungshalbleiterschaltelemente (7; 47; 53) im Betrieb mit einer erhöhten Ansteuerungsspannung (V_{GE}) angesteuert werden, deren Höhe oberhalb der für den Dauerbetrieb spezifizierten maximal zulässigen Ansteuerungsspannung liegt, um die mehreren Leistungshalbleiterschaltelemente (7; 47; 53) einzuschalten und einen erhöhten Stromfluss durch diese zu bewirken, dessen Stromstärke wenigstens dem doppelten Nennbetriebsstrom entspricht, und wobei die mehreren Leistungshalbleiterschaltelemente (7; 47; 53) nach einer Einschaltdauer durch Abschalten der Ansteuerungsspannung (V_{GE}) wieder ausgeschaltet werden, während sie einen erhöhten Stromfluss führen.

14. Verwendung nach Anspruch 13, **dadurch gekennzeichnet, dass** die Leistungshalbleiterschaltelemente (7; 47; 53) IGBTs sind und die Höhe der erhöhten Ansteuerungsspannung (V_{GE}) in Abhängigkeit von einer vorgegebenen gesamten Lebensdauer bis zu einem Durchbruch einer Gateoxidschicht zwischen einem Gate und einem Emitter der Leistungshalbleiterschaltelemente (7; 47; 53), einer erwarteten gesamten Einschaltdauer der Leistungshalbleiterschaltelemente als die Summe der geschätzten Einschaltdauern aller erwarteten Einschaltvorgänge und einer aufgrund der erwarteten Einschaltvorgänge und kurzzeitig erhöhten Arbeitstemperaturen geschätzten Reduktion der Lebensdauer gewählt wird, um die vorgegebene Lebensdauer zu erreichen, ohne dass es zu einer Beschädigung der Leistungshalbleiterschaltelemente (7; 47; 53) kommt.

15. Verwendung nach Anspruch 13 oder 14, **dadurch gekennzeichnet, dass** die Reihen- und/oder Parallelschaltung in einem hybriden Gleichstrom(DC)-Leistungsschalter (1), vorzugsweise für Hochspannungsgleichstromübertragungs(HGÜ)-Anwendungen, verwendet wird, wobei der hybride DC-Leistungsschalter (1) einen zu der Energieübertragungs- oder -verteilungsvorrichtung (14, 36) in Reihe geschalteten Hauptstromzweig (3), der eine Reihenschaltung aus einem elektronischen Hilfsschalter (11) und einem schnellen mechanischen Trennschalter (12) aufweist, und einen Bypasszweig (4) aufweist, der parallel zu dem Hauptstromzweig (3) angeschlossen ist und einen elektronischen Hauptschalter (6) enthält, der die Reihen- und/oder Parallelschaltung der mehreren Leistungshalbleiterschaltelemente (7) aufweist, wobei die Reihen- und/oder Parallelschaltung wenigstens 2 oder mehrere, für Hochspannungsanwendungen wenigstens 10 oder zig Leistungshalbleiterschaltelementen (7) Leistungshalbleiterschaltelemente aufweist.

16. Verwendung nach Anspruch 13 oder 14, **dadurch gekennzeichnet, dass** sie in einem Stromrichter (33, 37; 39), vorzugsweise für Hochspannungsgleichstromanwendungen, verwendet wird, wobei der Stromrichter (33, 37; 39) einen oder mehrere zueinander parallel geschaltete Zweige (41a-c) aufweist, wobei jeder Zweig (41a-c) wenigstens zwei in Reihe geschaltete elektronische Schalter (47; 52; 59) aufweist, die gemäß einem bestimmten Pulsmuster angesteuert werden, um eine erste Leistung mit ersten Strom- und Spannungseigenschaften in eine zweite Leistung mit zweiten Strom- und Spannungseigenschaften umzuwandeln, und wobei die wenigstens zwei in Reihe geschalteten elektronischen Schalter (47; 52; 59) jeweils mehrere in Reihe und/oder parallel geschaltete Leistungshalbleiterschaltelemente (47; 53) aufweisen, die im Normalbetrieb des Stromrichters mit der erhöhten Ansteuerungsspannung (V_{GE}) gemäß dem bestimmten Pulsmuster angesteuert werden.

17. Verwendung nach Anspruch 13 oder 14, **dadurch gekennzeichnet, dass** sie in einem zwei- oder mehrstufigen Stromrichter (33, 37; 39) verwendet wird, wobei der Stromrichter (33, 37; 39) wenigstens einen Gleichspannungszwischenkreis (48), einen oder mehrere zu dem wenigstens einen Gleichspannungszwischenkreis (48) und zueinander parallel geschaltete Zweige (41a-c) mit jeweils wenigstens zwei in Reihe geschalteten elektronischen Schaltern (47; 52; 59) aufweist, die gemäß einem bestimmten Pulsmuster angesteuert werden, um eine erste Leistung mit ersten Strom- und Spannungseigenschaften in eine zweite Leistung mit zweiten Strom- und Spannungseigenschaften umzuwandeln, und eine Chopper-Widerstands-Einrichtung (67) zum Schutz gegen Überspannung in dem wenigstens einen Gleichspannungszwischenkreis (48) aufweist, die parallel zu dem wenigstens einen Gleichspannungszwischenkreis (48) angeschlossen ist und eine Reihenschaltung aus wenigstens einem Widerstand (68) und einem elektronischen Schalter (69) aufweist, der durch die Reihen- und/oder Parallelschaltung mehrerer Leistungshalbleiterschaltelemente (47; 53) gebildet ist, die, wenn die Spannung in dem Gleichspannungszwischenkreis (48) eine vorgegebene Schwellspannung übersteigt, für kurze Zeit, pulsartig, ggf. wiederholt mit der erhöhten Ansteuerungsspannung (V_{GE}) angesteuert werden.
